# EUROPEAN PATENT APPLICATION

(11) **EP 4 561 320 A1**
(43) Date of publication of application: **28.05.2025**
(21) Application number: 24215139.7
(22) Date of filing: 25.11.2024
(51) Int. Cl.: H10K 59/122, H10K 59/80, H10K 50/844

(54) **DISPLAY PANEL AND METHOD OF MANUFACTURING THE SAME**

(30) Priority: 27.11.2023 KR 20230167271
(71) Applicant: Samsung Display Co., Ltd., Gyeonggi-Do (KR)
(72) Inventor: Yang, Hee Jun, Yongin-si, Gyeonggi-Do (KR); Sung, Woo Yong, Yongin-si, Gyeonggi-do (KR); Lee, Jeongseok, Yongin-si, Gyeonggi-Do (KR)
(74) Representative: Gulde & Partner

(57) **Abstract**

A display panel (DP) includes: a base layer (BL); a pixel defining film (PDL) on the base layer (BL) and in which a light emitting opening (OP-E) is defined; a partition wall (PW) on the pixel defining film (PDL) and in which a partition wall opening (OP-P) overlapping the light emitting opening (OP-E) is defined; a light emitting element (ED) including an anode (AE), an intermediate layer (EP), and a cathode (CE) in contact with the partition wall (PW) and located in the partition wall opening (OP-P); a lower encapsulation inorganic pattern (LIL) including a first part (P1) in the partition wall opening (OP-P), a second part (P2) extending from the first part (P1) in a thickness direction of the base layer (BL), and a third part (P3) extending from the second part (P2) in a direction away from the partition wall opening (OP-P) and spaced apart from the partition wall (PW) on a cross section; and a lower organic layer(BOL) between the third part (P3) of the lower encapsulation inorganic pattern (LIL) and the partition wall (PW).

## Description

### CROSS-REFERENCE TO RELATED APPLICATION

### BACKGROUND

### 1. Field

The present disclosure relates to a display panel and a method of manufacturing a display panel.

### 2. Description of the Related Art

Display devices such as televisions, monitors, smart phones, and tablet personal computers (PCs) that display images to users include display panels that display images. Various display panels such as liquid crystal display panels, organic light emitting display panels, electro wetting display panels, and electrophoretic display panels have been developed as the display panels.

An organic light emitting display panel may include an anode, a cathode, and a light emitting pattern. The light emitting pattern may be separated for each of light emitting areas, and the cathode may provide a common voltage to each of the light emitting areas.

The above information disclosed in this Background section is only for enhancement of understanding of the background and therefore the information discussed in this Background section does not necessarily constitute prior art.

### SUMMARY

The invention is defined by the appended claims. The description that follows is subjected to this limitation. Any disclosure lying outside the scope of said claims is only intended for illustrative as well as comparative purposes.

Aspects of some embodiments of the present disclosure relate to a display panel and a method of manufacturing a display panel, and for example, a display panel having relatively improved display quality.

Aspects of some embodiments of the present disclosure include a display panel forming a light emitting element without using a metal mask and having relatively improved display quality, and a method of manufacturing the same.

According to some embodiments of the present disclosure, a display panel includes a base layer, a pixel defining film on the base layer and in which a light emitting opening is defined, a partition wall on the pixel defining film and in which a partition wall opening overlapping the light emitting opening is defined, a light emitting element including an anode, an intermediate layer, and a cathode in contact with the partition wall and located in the partition wall opening, a lower encapsulation inorganic pattern including a first part in the partition wall opening, a second part extending from the first part in a thickness direction of the base layer, and a third part extending from the second part in a direction away from the partition wall opening and spaced apart from the partition wall on a cross section, and a lower organic layer between the third part of the lower encapsulation inorganic pattern and the partition wall.

According to some embodiments, the display panel may further include an encapsulation organic film on the lower encapsulation inorganic pattern, wherein the lower organic layer may be in contact with the encapsulation organic film.

According to some embodiments, the lower organic layer may include an inner part and a boundary part formed by surrounding the inner part in a plan view, and the boundary part and the encapsulation organic film may be in contact with each other.

According to some embodiments, the lower encapsulation inorganic pattern may include a first lower encapsulation inorganic pattern on the cathode and a second lower encapsulation inorganic pattern on the first lower encapsulation inorganic pattern, and the first lower encapsulation inorganic pattern may include a plurality of inorganic patterns repeatedly laminated. In other words, the first lower encapsulation inorganic pattern may include a plurality of inorganic patterns, which are repeating laminates.

According to some embodiments, a thickness of one inorganic patten among the plurality of inorganic patterns may be in a range of 175 nm to 200 nm.

According to some embodiments, the plurality of inorganic patterns may reflect a light having a wavelength of 350 nanometers (nm) to 400 nm.

According to some embodiments, thicknesses of the plurality of inorganic patterns may be the same.

According to some embodiments, each of the plurality of inorganic patterns may include a silicon nitride (SiNₓ).

According to some embodiments, each of the plurality of inorganic patterns may include a first sub pattern and a second sub pattern, and the first sub pattern and the second sub pattern may be sequentially and repeatedly laminated. In other words, the first sub pattern and the second sub pattern may be sequential and repeating laminates.

According to some embodiments, the first sub pattern may be richer in silicon (e.g., have a greater concentration of silicon) than the second sub pattern, and the second sub pattern may be richer in nitrogen (e.g., have a greater concentration of nitrogen) than the first sub pattern.

According to some embodiments, a thickness of the first sub pattern may be the same as a thickness of the second sub pattern.

According to some embodiments of the present disclosure, a display panel includes a base layer, a pixel defining film on the base layer and in which a light emitting opening is defined, a partition wall on the pixel defining film and in which a partition wall opening overlapping the light emitting opening is defined, a light emitting element including an anode, an intermediate layer, and a cathode in contact with the partition wall and located in the partition wall opening, a first lower encapsulation inorganic pattern that is on the cathode and reflects a light having an ultraviolet wavelength area, a second lower encapsulation inorganic pattern on the first lower encapsulation inorganic pattern, and a lower organic layer between the first lower encapsulation inorganic pattern and the partition wall.

According to some embodiments, the display panel may further include an encapsulation organic film on the second lower encapsulation inorganic pattern, wherein the lower organic layer may include an inner part and a boundary part in contact with the encapsulation organic film.

According to some embodiments, the first lower encapsulation inorganic pattern may include a plurality of inorganic patterns that are repeatedly laminated.

According to some embodiments, thicknesses of the plurality of inorganic patterns may be the same, and a thickness of one inorganic pattern among the plurality of inorganic patterns may be in a range of 175 nm to 200 nm.

According to some embodiments, each of the plurality of inorganic patterns may include a first sub pattern and a second sub pattern sequentially and repeatedly laminated, and the first sub pattern may include a silicon nitride (SiNₓ), which is richer in silicon (e.g., has a greater concentration of silicon) than the second sub pattern, and the second sub pattern may include a silicon nitride (SiNₓ), which is richer in nitrogen (e.g., has a greater concentration of nitrogen) than the first sub pattern.

According to some embodiments of the present disclosure, a method of manufacturing a display panel includes providing a preliminary display panel including a base layer, a pixel defining film on the base layer, a first preliminary partition wall layer on the pixel defining film, and a second preliminary partition wall layer on the first preliminary partition wall layer, etching the first preliminary partition wall layer and the second preliminary partition wall layer to form a first partition wall layer and a second partition wall layer in which a partition wall opening is defined, forming a light emitting pattern a cathode in the partition wall opening, forming a lower encapsulation inorganic pattern on the cathode, and forming a lower organic layer between the second partition wall layer and the lower encapsulation inorganic pattern.

According to some embodiments, the first preliminary partition wall layer and the second preliminary partition wall layer may form a preliminary partition wall and the etching of the first preliminary partition wall layer and the second preliminary partition wall layer may include an operation of forming a preliminary partition wall opening on the preliminary partition wall by using a photoresist layer as a mask and dry-etching the first preliminary partition wall layer and the second preliminary partition wall layer.

According to some embodiments, the method of manufacturing a display panel may include an operation of forming the first partition wall layer and the second partition wall layer, in which the partition wall opening is defined, by etching the first preliminary partition wall layer and the second preliminary partition wall layer so that the partition wall is formed from the preliminary partition wall.

According to some embodiments, the etching of the first preliminary partition wall layer and the second preliminary partition wall layer to form a first partition wall layer and a second partition wall layer may include a primary dry etching process, wherein the primary dry etching process may be performed in an etching environment in which an etching selection ratio between the first preliminary partition wall layer and the second preliminary partition wall layer is substantially the same. Accordingly, an inner surface of the first preliminary partition wall layer and an inner surface of the second preliminary partition wall layer, which define the preliminary partition wall opening may be substantially aligned with each other.

According to some embodiments, the etching of the first preliminary partition wall layer and the second preliminary partition wall layer to form a first partition wall layer and a second partition wall layer may include an operation of forming the partition wall opening from the preliminary partition wall opening by using the photoresist layer as a mask and wet etching the first preliminary partition wall layer.

According to some embodiments, the etching of the first preliminary partition wall layer and the second preliminary partition wall layer to form a first partition wall layer and a second partition wall layer may include a secondary dry etching process, wherein the secondary dry etching process may be performed in an environment in which the etching selection ratio between the first preliminary partition wall layer and the second preliminary partition wall layer is large. Accordingly, an inner surface of the partition wall defining the partition wall opening may have an undercut shape on a cross section. For example, as an etch rate of the first partition wall layer with respect to an etching solution is greater than an etch rate of the second partition wall layer with respect to the etching solution, the first partition wall layer may be mainly etched. Accordingly, a first inner surface of the first partition wall layer may be formed to be more recessed inward than a second inner surface of the second partition wall layer. A tip portion may be formed in the partition wall by a portion of the second partition wall layer protruding further from the first partition wall layer.

According to some embodiments, the preliminary display panel may include an anode and a sacrificial layer and the method of manufacturing the display panel may include forming the anode and the sacrificial layer. The pixel defining film may be located on the base layer. The pixel defining film PDL may cover the anode and the sacrificial layer.

According to some embodiments, the method of manufacturing a display panel may include an operation of etching the pixel defining film and an operation of etching a sacrificial layer. The etching of the pixel defining film may be performed in a dry etching method, and the etching may be performed using the photoresist layer and the partition wall as a mask. A light emitting opening corresponding to the partition wall opening may be formed in the pixel defining film.

According to some embodiments, the etching of the sacrificial layer may be performed in a wet etching method, and the etching may be performed using the photoresist layer and the partition wall as a mask. A sacrificial opening overlapping the light emitting opening may be formed in a sacrificial pattern formed by etching the sacrificial layer. At least a portion of the anode may be exposed from the sacrificial pattern and the pixel defining film by the sacrificial opening and the light emitting opening.

According to some embodiments, the etching process of the sacrificial pattern may be performed in an environment in which an etching selection ratio between the sacrificial pattern and the anode is high, and therefore, the anode may be prevented from being etched together. That is, as the sacrificial pattern having a higher etch rate than that of the anode arranged between the pixel defining film and the anode, the anode may be prevented from being etched together and damaged during the etching process.

Etching selection ratio or etch selectivity may be the ratio of etch rates between materials. The formula for etch selectivity is selectivity = etch rate A/etch rate B. It is used for example when describing the relative etch rates between a mask (used for patterning) and the etch rate of the material of interest or to describe the relative etch rates between different layers of materials. A selectivity of greater than 5:1 may be a high selectivity. In some cases, selectivity may be greater than 100:1.

According to some embodiments, the method of manufacturing a display panel may include an operation of forming the light emitting pattern and the cathode inside the partition wall opening after removing the photoresist layer.

According to some embodiments, the operation of forming the light emitting pattern may be performed through a deposition process.

According to some embodiments, the operation of forming the light emitting pattern may include a thermal evaporation process. The light emitting pattern may be formed on the anode. The light emitting pattern may be separated by the tip portion formed in the partition wall and located inside the light emitting opening and the partition wall opening.

According to some embodiments, in the operation of forming the light emitting pattern, a (1-1)^{th} dummy layer spaced apart from the light emitting pattern may be formed on the partition wall together. The (1-1)^{th} dummy layer may include an organic material. The (1-1)^{th} dummy layer may include the same material as the light emitting pattern. The (1-1)^{th} dummy layer together with the light emitting pattern may be simultaneously formed through one process and formed separately from the light emitting pattern by the undercut shape of the partition wall.

According to some embodiments, in the operation of forming the cathode may be performed through a deposition process.

According to some embodiments, the operation of forming the cathode may include a sputtering process. The cathode may be formed on the light emitting pattern. The cathode may be separated by the tip portion formed in the partition wall and located inside the partition wall opening. The cathode may be provided at a higher input angle than that of the light emitting pattern, and the cathode may be formed in contact with the first inner surface of the partition wall layer. The anode, the light emitting pattern, and the cathode may constitute a light emitting element.

According to some embodiments, in the operation of forming the cathode, a (2-1)^{th} dummy layer spaced apart from the cathode may be formed on the partition wall together. The (2-1)^{th} dummy layer may include a conductive material. The cathode and the (2-1)^{th} dummy layer may include the same material. The (2-1)^{th} dummy layer together with the cathode may be simultaneously formed through one process and formed separately from the cathode by the undercut shape of the partition wall.

According to some embodiments, the forming of the lower organic layer may include depositing a preliminary lower organic layer on the second partition wall layer and the lower encapsulation inorganic pattern, irradiating the preliminary lower organic layer with a light, and removing a remaining portion of the preliminary lower organic layer except for a portion of the preliminary lower organic layer formed under the lower encapsulation inorganic pattern.

According to some embodiments, the forming of the lower encapsulation inorganic pattern may include depositing a (1-1)^{th} sub layer on the cathode, depositing a (2-1)^{th} sub layer on the (1-1)^{th} sub layer, wherein the (1-1)^{th} sub layer and the (2-1)^{th} sub layer form a first inorganic layer, and a thickness of the first inorganic layer may be a half of a wavelength of the light.

According to some embodiments, the depositing of the (1-1)^{th} sub layer on the cathode may include inputting a gas containing silicon and an argon gas, and inputting a gas containing nitrogen and the argon gas.

According to some embodiments, the depositing of the (2-1)^{th} sub layer on the (1-1)^{th} sub layer may include inputting a gas containing silicon, a gas containing nitrogen, and an argon gas, and inputting the gas containing nitrogen and the argon gas.

### BRIEF DESCRIPTION OF THE DRAWINGS

The above and other aspects and features of embodiments according to the present disclosure will become more apparent by describing in more detail aspects of some embodiments thereof with reference to the accompanying drawings.
FIG. 1A is a perspective view of a display device according to some embodiments of the present disclosure.
FIG. 1B is an exploded perspective view of the display device according to some embodiments of the present disclosure.
FIG. 2 is a cross-sectional view of a display module according to some embodiments of the present disclosure.
FIG. 3 is a plan view of a display panel according to some embodiments of the present disclosure.
FIG. 4 is an enlarged plan view of a portion of a display area of the display panel according to some embodiments of the present disclosure.
FIG. 5 is a cross-sectional view of the display panel along the line I-I' of FIG. 3 according to some embodiments of the present disclosure.
FIG. 6 is an enlarged view of the area AA' of FIG. 5.
FIG. 7 is a cross-sectional view along the line II-II' of FIG. 4.
FIGS. 8A to 8N are cross-sectional views or schematic views illustrating some of operations of a method of manufacturing the display panel according to some embodiments of the present disclosure.
FIGS. 9A to 9E are cross-sectional views illustrating some of operations of the method of manufacturing the display panel according to some embodiments of the present disclosure.

### DETAILED DESCRIPTION

In the specification, the expression that a first component (or area, layer, part, portion, etc.) is "on", "connected with", or "coupled to" a second component means that the first component is directly on, connected with, or coupled to the second component or means that a third component is located therebetween.

The same reference numerals refer to the same components. Further, in the drawings, the thickness, the ratio, and the dimension of components are exaggerated for effective description of technical contents. The expression "and/or" includes one or more combinations which associated components are capable of defining.

Although the terms "first", "second", etc. may be used to describe various components, the components should not be limited by the terms. The terms are only used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

Unless otherwise defined, all terms (including technical terms and scientific terms) used in this specification have the same meaning as commonly understood by those skilled in the art to which the present disclosure belongs. Furthermore, terms such as terms defined in the dictionaries commonly used should be interpreted as having a meaning consistent with the meaning in the context of the related technology, and should not be interpreted in ideal or overly formal meanings unless explicitly defined herein.

Hereinafter, aspects of some embodiments of the present disclosure will be described in more detail with reference to the accompanying drawings.

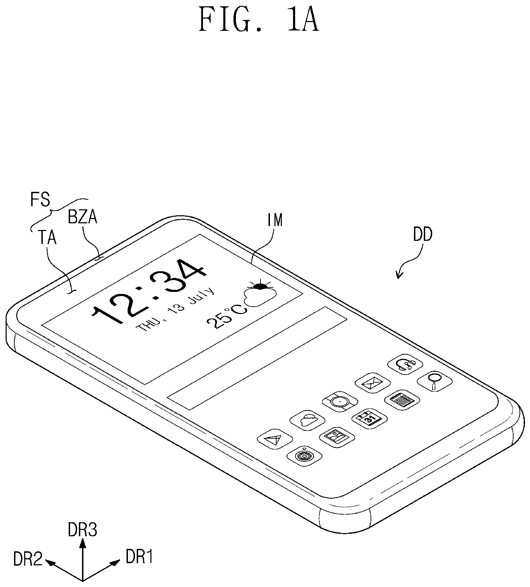

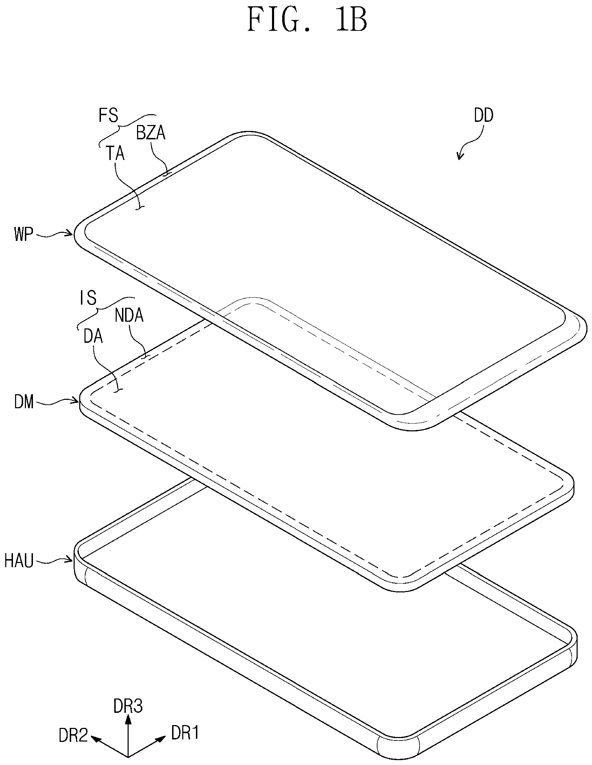

FIG. 1A is a perspective view of a display device DD according to some embodiments of the present disclosure, and FIG. 1B is an exploded perspective view of the display device DD according to some embodiments of the present disclosure.

According to some embodiments, the display device DD may be a large electronic device such as a television, a monitor, or an external billboard. Further, the display device DD may be a small or medium-sized electronic device such as a personal computer (PC), a laptop, a personal digital terminal, a vehicle navigation unit, a game console, a smart phone, a tablet PC, and a camera. However, this is illustrative, and other display devices may be adopted as long as the display devices do not deviate from the concept of embodiments according to the present disclosure. FIGS. 1A and 1B illustratively illustrate that the display device DD is a smart phone.

Referring to FIGS. 1A and 1B, the display device DD may display an image IM in a third direction DR3 on a display surface FS parallel to a first direction DR1 and a second direction DR2. The image IM may include a still image (e.g., a static image) as well as a dynamic image (e.g., video images). In FIG. 1A, a watch window and icons are illustrated as an example of the image IM. The display surface FS on which the image IM is displayed may correspond to a front surface of the display device DD.

According to some embodiments, a front surface (or an upper surface) and a rear surface (or a lower surface) of each member are defined with respect to a direction, in which the image IM is displayed. The front surface and the rear surface may face each other in the third direction DR3, and a normal direction of each of the front and rear surfaces may be parallel to the third direction DR3. Meanwhile, directions indicated by the first to third directions DR1, DR2, and DR3 are relative concepts and may be changed to other directions. In the specification, a phrases of "on a plane" or "in a plan view" refers to a state when viewed in or from the third direction DR3.

The display device DD may include a window WP, a display module DM, and a housing HAU. The window WP and the housing HAU may be coupled to each other to constitute an exterior of the display device DD.

The window WP may include an optically transparent insulating material. For example, the window WP may include a glass or plastic. A front surface of the window WP may define the display surface FS of the display device DD. The display surface FS may include a transmissive area TA and a bezel area BZA. The transmissive area TA may be an optically transparent area. For example, the transmissive area TA may be an area having a visible light transmittance of about 90% or more.

The bezel area BZA may be an area having a relatively lower light transmittance than that of the transmissive area TA. The bezel area BZA may define a shape of the transmissive area TA. The bezel area BZA may be adjacent to (e.g., in a periphery or outside a footprint of) the transmissive area TA and surround the transmissive area TA. However, this is illustrative, and the bezel area BZA of the window WP may be omitted. The window WP may include at least one functional layer of a fingerprint preventing layer, a hard coating layer, and a reflection preventing layer, and is not limited thereto.

The display module DM may be located under the window WP. The display module DM may be a component that substantially generates the image IM. The image IM generated by the display module DM is displayed on a display surface IS of the display module DM and is visually recognized by a user from the outside through the transmissive area TA.

The display module DM may include a display area DA and a non-display area NDA. The display area DA may be an area that is activated according to an electric signal. The non-display area NDA may be adjacent to (e.g., in a periphery or outside a footprint of) the display area DA. The non-display area NDA may surround the display area DA. The non-display area NDA is an area covered by the bezel area BZA and may not be visually recognized or perceived by users from the outside.

The housing HAU may be coupled to the window WP. The housing HAU may be coupled to the window WP to provide an inner space (e.g., a set or predetermined inner space) or cavity. The display module DM may be accommodated in the inner space.

The housing HAU may include a material having a relatively high rigidity. For example, the housing HAU may include a plurality of frames and/or plates including a glass, a plastic, or a metal or made of a combination thereof. The housing HAU may stably protect components of the display device DD accommodated in the inner space from an external impact.

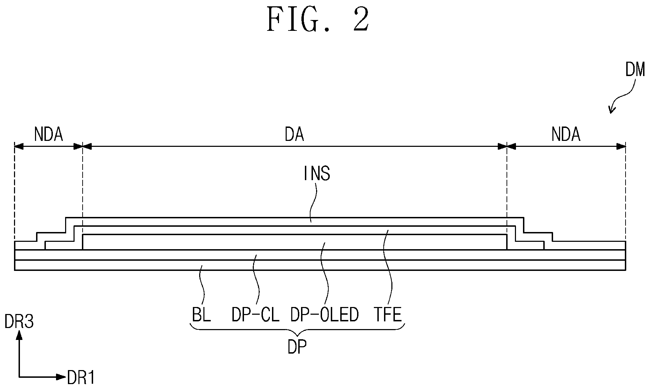

FIG. 2 is a cross-sectional view of the display module DM according to some embodiments of the present disclosure.

Referring to FIG. 2, the display module DM may include a display panel DP and an input sensor INS. According to some embodiments, the display device DD (see FIG. 1A) according to some embodiments of the present disclosure may further include a protective member located on a lower surface of the display panel DP or a reflection preventing member and/or a window member located on an upper surface of the input sensor INS.

The display panel DP may be a light emitting display panel. However, this is illustrative, and the present disclosure is not particularly limited thereto. For example, the display panel DP may be an organic light emitting display panel or an inorganic light emitting display panel. A light emitting layer in the organic light emitting display panel may include an organic light emitting material. A light emitting layer in the inorganic light emitting display panel may include a quantum dot, a quantum rod, or a micro light emitting diode (LED). Hereinafter, the display panel DP will be described as the organic light emitting display panel.

The display panel DP may include a base layer BL, and a circuit element layer DP-CL, a display element layer DP-OLED, and a thin film encapsulation layer TFE which are arranged on the base layer BL. The input sensor INS may be directly located on the thin film encapsulation layer TFE. In the specification, the wording "component A is directly located on component B" means that no adhesive layer is located between component A and component B.

The base layer BL may include at least one plastic film. The base layer BL is a flexible substrate and may include a plastic substrate, a glass substrate, a metal substrate, or an organic/inorganic composite material substrate. The display area DA and the non-display area NDA described in FIG. 1B may be equally defined in the base layer BL.

The circuit element layer DP-CL may include at least one insulating layer and a circuit element. The insulating layer includes at least one inorganic layer and at least one organic layer. The circuit element includes signal lines, a driving circuit of a pixel, and the like.

The display element layer DP-OLED may include a partition wall and a light emitting element. The light emitting element may include an anode, an intermediate layer, and a cathode.

The thin film encapsulation layer TFE may include a plurality of thin films. Some thin films may be arranged to relatively improve optical efficiency, and some thin films may be arranged to protect organic light emitting diodes.

The input sensor INS acquires coordinate information of an external input. The input sensor INS may have a multilayer structure. The input sensor INS may include a single-layered or multi-layered conductive layer. Further, the input sensor INS may include a single-layered or multi-layered insulating layer. The input sensor INS may sense an external input in a capacitive manner. However, this is illustrative, and the present disclosure is not limited thereto. For example, according to some embodiments, the input sensor INS may also sense an external input in an electromagnetic induction manner or a pressure sensing manner. Meanwhile, according to some embodiments of the present disclosure, the input sensor INS may be omitted.

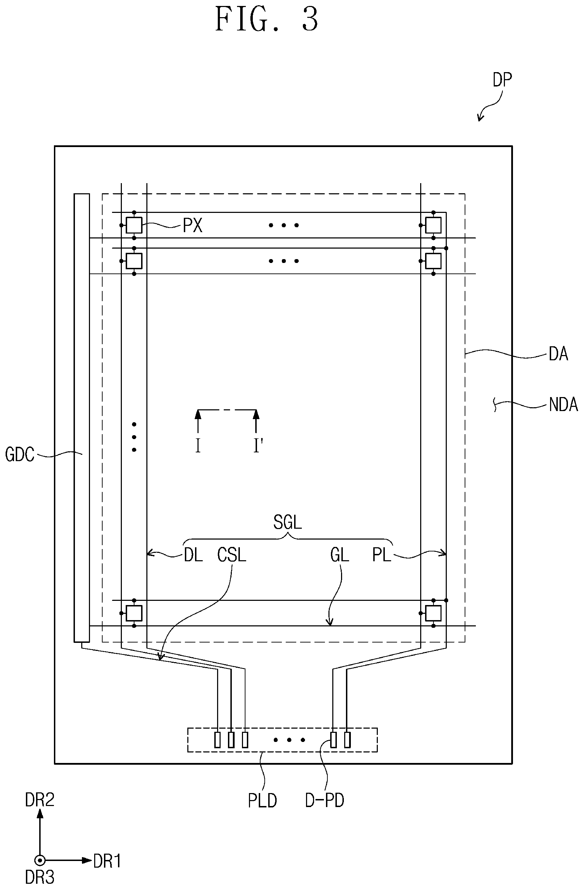

FIG. 3 is a plan view of the display panel DP according to some embodiments of the present disclosure.

Referring to FIG. 3, the display area DA and the non-display area NDA around the display area DA may be defined in the display panel DP. The display panel DP may include pixels PX and signal lines SGL electrically connected to the pixels PX. The display panel DP may include a driving circuit GDC and a pad part PLD. The display area DA and the non-display area NDA may be distinguished depending on whether a pixel PX is located. The pixel PX may be located in the display area DA. The driving circuit GDC and the pad part PLD may be arranged in the non-display area NDA.

The pixels PX may be arranged in the first direction DR1 and the second direction DR2. The pixels PX may include a plurality of pixel rows extending in the first direction DR1 and arranged in the second direction DR2 and a plurality of pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel among the pixels PX, and each of the data lines DL may be connected to a corresponding pixel among the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signal to the gate lines GL. The gate driving circuit may further output another control signal to a pixel driving circuit.

The pad part PLD may be a portion to which a flexible circuit board is connected. The pad part PLD may include pixel pads D-PD, and the pixel pads D-PD may be pads for connecting the flexible circuit board to the display panel DP. Each of the pixel pads D-PD may be connected to a corresponding signal line among the signal lines SGL. The pixel pads D-PD may be connected to the corresponding pixels PX through the signal lines SGL. Further, any one pixel pad among the pixel pads D-PD may be connected to the driving circuit GDC.

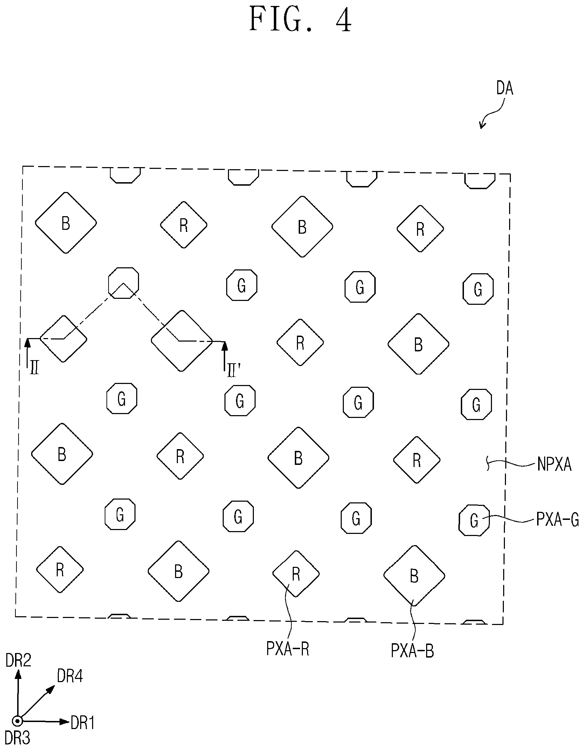

Further, the pad part PLD may further include input pads. The input pads may be pads for connecting the flexible circuit board to the input sensor INS (see FIG. 2). However, the present disclosure is not limited thereto, and the input pads may be arranged in the input sensor INS (see FIG. 2) and connected to the pixel pads D-PD and a separate circuit board. Alternatively, the input sensor INS (see FIG. 2) may be omitted and may not further include the input pads. FIG. 4 is an enlarged plan view of a portion of the display area DA (see FIG. 2) of the display panel DP (see FIG. 2) according to some embodiments of the present disclosure. FIG. 4 illustrates a plan view of the display module DM when viewed from the display surface IS (see FIG. 1B) of the display module DM (see FIG. 1B) and illustrates arrangement of light emitting areas PXA-R, PXA-G, and PXA-B.

Referring to FIG. 4, the display area DA may include the first to third light emitting areas PXA-R, PXA-G, and PXA-B and a peripheral area NPXA surrounding the first to third light emitting areas PXA-R, PXA-G, and PXA-B. The first to third light emitting areas PXA-R, PXA-G, and PXA-B may respectively correspond to areas from which lights provided from the light emitting elements are emitted. The first to third light emitting areas PXA-R, PXA-G, and PXA-B may be classified according to a color of a light emitted toward the outside of the display module DM (see FIG. 2).

The first to third light emitting areas PXA-R, PXA-G, and PXA-B may provide first to third color lights having different colors, respectively. For example, the first color light may be a red light, the second color light may be a green light, and the third color light may be a blue light. However, examples of the first to third color lights are not necessarily limited to the above example.

Each of the first to third light emitting areas PXA-R, PXA-G, and PXA-B may be defined as an area in which an upper surface of the anode is exposed by a light emitting opening, which will be described below. The peripheral area NPXA may set boundaries between the first to third light emitting areas PXA-R, PXA-G, and PXA-B and prevent color mixing between the first to third light emitting areas PXA-R, PXA-G, and PXA-B.

The first to third light emitting areas PXA-R, PXA-G, and PXA-B may be provided such that all of the numbers thereof are plural and may be repeatedly arranged in the display area DA in a specific arrangement form. For example, the first and third light emitting areas PXA-R and PXA-B may be alternately arranged in the first direction DR1 to constitute a "first group." The second light emitting areas PXA-G may arranged in the first direction DR1 to constitute a "second group." Each of the "first group" and the "second group" may be provided in plurality, and the "first groups" and the "second groups" may be alternately arranged in the second direction DR2.

One second light emitting area PXA-G may be spaced apart from one first light emitting area PXA-R or one third light emitting area PXA-B in a fourth direction DR4. The fourth direction DR4 may be defined as a direction between the first and second directions DR1 and DR2.

Meanwhile, FIG. 4 illustratively illustrates an arrangement form of the first to third light emitting areas PXA-R, PXA-G, and PXA-B, but embodiments according to the present disclosure are not limited thereto, and the first to third light emitting areas PXA-R, PXA-G, and PXA-B may be arranged in various forms. According to some embodiments, as illustrated in FIG. 4, the first to third light emitting areas PXA-R, PXA-G, and PXA-B may have a PENTILE^{®} arrangement form. Alternatively, the first to third light emitting areas PXA-R, PXA-G, and PXA-B may also have a stripe arrangement form or a diamond pixel^{®} arrangement form.

The first to third light emitting areas PXA-R, PXA-G, and PXA-B may have various shapes on a plane (or in a plan view). For example, the first to third light emitting areas PXA-R, PXA-G, and PXA-B may have shapes such as a polygonal shape, a circular shape, or an elliptic shape. FIG. 4 illustratively illustrates the first and third light emitting areas PXA-R and PXA-B having a quadrangular shape (or a diamond shape) and the second light emitting area PXA-G having an octagonal shape on a plane (or in a plan view).

The first to third light emitting areas PXA-R, PXA-G, and PXA-B may have the same shape on a plane (or in a plan view) or may have at least partially different shapes. FIG. 4 illustratively illustrates the first and third light emitting areas PXA-R and PXA-B having the same shape and the second light emitting area PXA-G having a shape different from that of the first and third light emitting areas PXA-R and PXA-B on a plane (or in a plan view).

At least some of the first to third light emitting areas PXA-R, PXA-G, and PXA-B may have different areas on a plane (or in a plan view). According to some embodiments, an area of the first light emitting area PXA-R that emits a red light may be greater than an area of the second light emitting area PXA-G that emits a green light and may be smaller than an area of the third light emitting area PXA-B that emits a blue light. However, a size relationship between the areas of the first to third light emitting areas PXA-R, PXA-G, and PXA-B according to the color of the emitted light is not limited thereto and may be varied depending on a design of the display module DM (see FIG. 2). Further, embodiments according to the present disclosure are not limited thereto, and the first to third light emitting areas PXA-R, PXA-G, and PXA-B may also have the same area on a plane (or in a plan view).

Meanwhile, the shape, the area, the arrangement, and the like of the first to third light emitting areas PXA-R, PXA-G, and PXA-B of the display module DM (see FIG. 2) of the present disclosure may be variously designed according to the color of the emitted light or the size and configuration of the display module DM (see FIG. 2) and are not limited to the embodiments illustrated in FIG. 4.

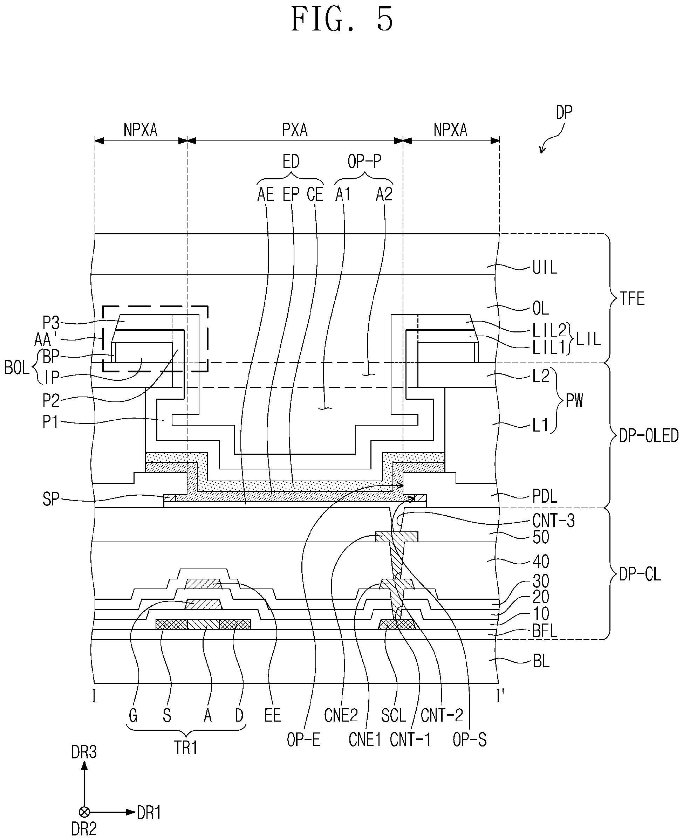

FIG. 5 is a cross-sectional view of the display panel DP along the line I-I' of FIG. 3 according to some embodiments of the present disclosure. In description of FIG. 5, the description will be made with reference to FIG. 2, and descriptions for the same reference numerals will be omitted.

FIG. 5 enlargedly illustrates one light emitting area PXA in the display area DA (see FIG. 4), and the light emitting area PXA of FIG. 5 may correspond to one of the first to third light emitting areas PXA-R, PXA-G, and PXA-B of FIG. 4. Referring to FIG. 5, the display panel DP may include the base layer BL, the circuit element layer DP-CL, the display element layer DP-OLED, and the thin film encapsulation Layer TFE.

The display panel DP may include a plurality of insulating layers, a plurality of semiconductor patterns, a plurality of conductive patterns, a plurality of signal lines, and the like. The insulating layer, the semiconductor layer, and the conductive layer are formed by coating, deposition, or the like. Thereafter, the insulating layer, the semiconductor layer, and the conductive layer may be selectively patterned by photolithography and etching. In this manner, the semiconductor pattern, the conductive pattern, the signal line, and the like included in the circuit element layer DP-CL and the display element layer DP-OLED may be formed.

The circuit element layer DP-CL may be located on the base layer BL. The circuit element layer DP-CL may include a buffer layer BFL, a transistor TR1, a signal transmitting area SCL, first to fifth insulating layers 10, 20, 30, 40, and 50, an electrode EE, and a plurality of connection electrodes CNE1 and CNE2.

The buffer layer BFL may be located on the base layer BL. The buffer layer BFL may relatively improve a coupling force between the base layer BL and the semiconductor pattern. The buffer layer BFL may include a silicon oxide layer and a silicon nitride layer. The silicon oxide layer and the silicon nitride layer may be alternately laminated.

The semiconductor pattern may be located on the buffer layer BFL. The semiconductor pattern may include polysilicon. However, embodiments according to the present disclosure are not limited thereto, and the semiconductor pattern may include amorphous silicon or metal oxide. FIG. 5 illustratively illustrates a portion of the semiconductor pattern, and the semiconductor patterns may be further arranged in the plurality of light emitting areas PXA-R, PXA-G, and PXA-B (see FIG. 4). The semiconductor pattern may be arranged in a specific rule across the plurality of light emitting areas PXA-R, PXA-G, and PXA-B. The semiconductor pattern may have a different electrical property depending on whether or not the semiconductor pattern is doped. The semiconductor pattern may include a first area having a high doping concentration and a second area having a low doping concentration. The first area may be doped with an N-type dopant or a P-type dopant. A P-type transistor may include the first area doped with the P-type dopant.

A conductivity of the first area is greater than a conductivity of the second area, and the first area may substantially serve as an electrode or a signal line. The second area may substantially correspond to an active (or a channel) of a transistor. In other words, a portion of the semiconductor pattern may be the active of the transistor, another portion of the semiconductor pattern may be a source or a drain of the transistor, and still another portion of the semiconductor pattern may be a conductive area.

A source S, an active A, and a drain D of the transistor TR1 may be formed from the semiconductor pattern. FIG. 5 illustrates a portion of the signal transmitting area SCL formed from the semiconductor pattern. According to some embodiments, the signal transmitting area SCL may be connected to the drain D of the transistor TR1 on a plane (or in a plan view).

The first to fifth insulating layers 10, 20, 30, 40, and 50 may be arranged on the buffer layer BFL. The first to fifth insulating layers 10, 20, 30, 40, and 50 may be inorganic layers or organic layers.

The first insulating layer 10 may be located on the buffer layer BFL. The first insulating layer 10 may cover the source S, the active A, and the drain D of the transistor TR1 located on the buffer layer BFL, and the signal transmitting area SCL. A gate G of the transistor TR1 may be located on the first insulating layer 10. The second insulating layer 20 may be located on the first insulating layer 10 to cover the gate G. The electrode EE may be located on the second insulating layer 20. The third insulating layer 30 may be located on the second insulating layer 20 to cover the electrode EE.

The first connection electrode CNE1 may be located on the third insulating layer 30. The first connection electrode CNE1 may be connected to the signal transmitting area SCL through a contact hole CNT-1 passing through the first to third insulating layers 10, 20, and 30. The fourth insulating layer 40 may be located on the third insulating layer 30 to cover the first connection electrode CNE1. The fourth insulating layer 40 may be an organic layer.

The second connection electrode CNE2 may be located on the fourth insulating layer 40. The second connection electrode CNE2 may be connected to the first connection electrode CNE1 through a contact hole CNT-2 passing through the fourth insulating layer 40. The fifth insulating layer 50 may be located on the fourth insulating layer 40 to cover the second connection electrode CNE2. The fifth insulating layer 50 may be an organic layer.

The display element layer DP-OLED may be located on the circuit element layer DP-CL. The display element layer DP-OLED may include a light emitting element ED, a sacrificial pattern SP, a pixel defining film PDL, and a partition wall PW.

The light emitting element ED may include an anode AE (or a first electrode), a light emitting pattern EP, and a cathode CE (or a second electrode).

The anode AE may be located on the fifth insulating layer 50 of the circuit element layer DP-CL. The anode AE may be a transmissive electrode, a semi-transmissive electrode, or a reflective electrode. The anode AE may be connected to the second connection electrode CNE2 through a connection contact hole CNT-3 defined through the fifth insulating layer 50. Thus, the anode AE may be electrically connected to the signal transmitting area SCL through the first and second connection electrodes CNE1 and CNE2 and thus electrically connected to the corresponding circuit element. The anode AE may include a single-layer structure or a multi-layer structure. The anode AE may include a plurality of layers including ITO and Ag. For example, the anode AE may include a layer including the ITO (hereinafter, referred to as a lower ITO layer), a layer located on the lower ITO layer and including Ag (hereinafter, referred to as an Ag layer), and a layer located on the Ag layer and including the ITO (hereinafter, referred to as an upper ITO layer).

The sacrificial pattern SP may be located between the anode AE and the pixel defining film PDL. A sacrificial opening OP-S through which a portion of an upper surface of the anode AE is exposed may be defined in the sacrificial pattern SP. The sacrificial opening OP-S may overlap a light emitting opening OP-E, which will be described below.

The pixel defining film PDL may be located on the fifth insulating layer 50 of the circuit element layer DP-CL. The light emitting opening OP-E may be defined by the pixel defining film PDL. The light emitting opening OP-E may correspond to the anode AE, and the pixel defining film PDL may expose at least a portion of the anode AE through the light emitting opening OP-E.

Further, the light emitting opening OP-E may correspond to the sacrificial opening OP-S of the sacrificial pattern SP. According to some embodiments, the upper surface of the anode AE may be spaced apart from the pixel defining film PDL in a cross section with the sacrificial pattern SP interposed therebetween, and accordingly, damage to the anode AE may be protected in a process of forming the light emitting opening OP-E.

On a plane (or in a plan view), an area of the light emitting opening OP-E may be smaller than an area of the sacrificial opening OP-S. That is, an inner surface of the pixel defining film PDL defining the light emitting opening OP-E may be closer to a center of the anode AE than an inner surface of the sacrificial pattern SP defining the sacrificial opening OP-S. However, embodiments according to the present disclosure are not limited thereto, and the inner surface of the sacrificial pattern SP defining the sacrificial opening OP-S may be substantially aligned with the inner surface of the pixel defining film PDL defining the light emitting opening OP-E. In this case, the light emitting area PXA may be regarded as an area of the anode AE exposed from the corresponding sacrificial opening OP-S.

The pixel defining film PDL may include an inorganic insulating material. For example, the pixel defining film PDL may include a silicon nitride (SiNx). The pixel defining film PDL may be located between the anode AE and a partition wall PW and block electrical connection between the anode AE and the partition wall PW.

The light emitting pattern EP may be located on the anode AE. The light emitting pattern EP may include a light emitting layer including a light emitting material. The light emitting pattern EP may further include a hole injection layer (HIL) and a hole transport layer (HTL) arranged between the anode AE and the light emitting layer and may further include an electron transport layer (ETL) and an electron injection layer (EIL) arranged on the light emitting layer. The light emitting pattern EP may be referred to an "organic layer" or an "intermediate layer."

The light emitting pattern EP may be patterned by a tip portion defined by the partition wall PW. The light emitting pattern EP may be located inside the sacrificial opening OP-S, the light emitting opening OP-E, and a partition wall opening OP-P. The light emitting pattern EP may cover a portion of the upper surface of the pixel defining film PDL exposed from the partition wall opening OP-P.

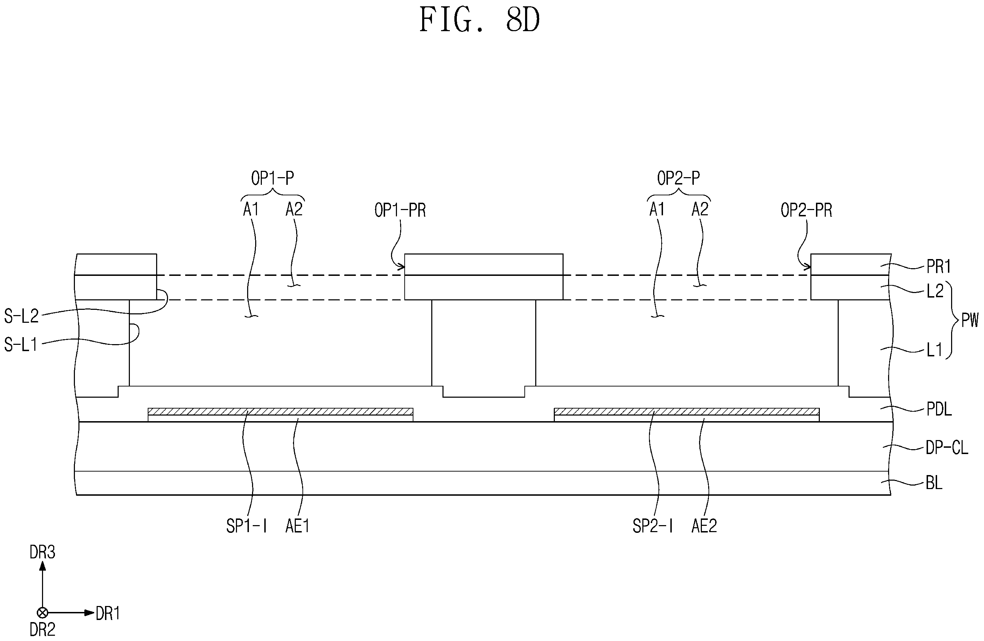

The cathode CE may be located on the light emitting pattern EP. The cathode CE may be patterned by the tip portion defined by the partition wall PW. At least a portion of the cathode CE may be located in the partition wall opening OP-P. The cathode CE may be in contact with a first inner surface S-L1 (see FIG. 8D) of a first partition wall layer L1. The cathode CE may be conductive. The cathode CE may be formed of various materials such as a metal, a transparent conductive oxide (TCO), and a conductive polymer material as long as the materials may be conductive. For example, the cathode CE may include silver (Ag), magnesium (Mg), lead (Pb), copper (Cu), or compounds thereof.

The partition wall PW may be located on the pixel defining film PDL. The partition wall opening OP-P may be defined in the partition wall PW. The partition wall opening OP-P may correspond to the light emitting opening OP-E and expose at least a portion of the anode AE.

The partition wall PW may have an undercut shape on a cross section. The partition wall PW may include a plurality of layers that are sequentially laminated, and at least one layer of the plurality of layers may be recessed as compared to other layers. Accordingly, the partition wall PW may include the tip portion.

The partition wall PW may include the first partition wall layer L1 and a second partition wall layer L2. The first partition wall layer L1 may be located on the pixel defining film PDL, and the second partition wall layer L2 may be located on the first partition wall layer L1. As illustrated in FIG. 5, a thickness of the first partition wall layer L1 may be greater than a thickness of the second partition wall layer L2, but embodiments according to the present disclosure are not limited thereto.

The first partition wall layer L1 may be relatively recessed with respect to the light emitting area PXA as compared to the second partition wall layer L2. The first partition wall layer L1 may be formed to be undercut with respect to the second partition wall layer L2. A portion of the second partition wall layer L2, which protrudes from the first partition wall layer L1 toward the light emitting area PXA, may be defined as the tip portion inside the partition wall PW.

The partition wall opening OP-P defined in the partition wall PW may include a first area A1 and a second area A2. The first partition wall layer L1 may include a first inner surface defining the first area A1 of the partition wall opening OP-P, and the second partition wall layer L2 may include a second inner surface defining the second area A2. On a cross section, a second inner surface of the second partition wall layer L2 may be closer to the center of the anode AE than a first inner surface of the first partition wall layer L1. The first inner surface may be recessed from the second inner surface in a direction away from the center of the anode AE. Accordingly, the second partition wall layer L2 protruding toward the light emitting area PXA may include the tip portion.

A width of the first area A1 may be different from a width of the second area A2. The width of the first area A1 may be greater than the width of the second area A2. In this case, the second area A2 of the partition wall opening OP-P may be an area defining the tip portion.

The first partition wall layer L1 and the second partition wall layer L2 may include a conductive material. For example, the conductive material may include a metal, a TCO, or a combination thereof. For example, the metal includes gold (Au), silver (Ag), aluminum (Al), magnesium (Mg), lithium (Li), molybdenum (Mo), titanium (Ti), copper (Cu), or alloys thereof. The TCO may include an indium tin oxide (ITO), an indium zinc oxide (IZO), a zinc oxide, an indium oxide, an indium gallium oxide, an indium gallium zinc oxide (IGZO) or an aluminum zinc oxide.

FIG. 5 illustratively illustrates that each of the first inner surface and the second inner surface is perpendicular to an upper surface of the pixel defining film PDL, but embodiments according to the present disclosure are not limited thereto. For example, the partition wall PW may have a tapered shape or a reverse tapered shape.

The partition wall PW may receive a second driving voltage, and accordingly, the cathode CE may be electrically connected to the partition wall PW to receive the second driving voltage.

The thin film encapsulation layer TFE may be located on the display element layer DP-OLED. The thin film encapsulation layer TFE may include a lower encapsulation inorganic pattern LIL, an encapsulation organic film OL, and an upper encapsulation inorganic film UIL.

The lower encapsulation inorganic pattern LIL may correspond to the light emitting opening OP-E. The lower encapsulation inorganic pattern LIL may be located on the cathode CE. For example, the lower encapsulation inorganic pattern LIL may include a first part P1, a second part P2, and a third part P3. The first part P1 of the lower encapsulation inorganic pattern LIL may be located inside the partition wall opening OP-P, and the second part P2 of the lower encapsulation inorganic pattern LIL may extend from the first part P1 in a thickness direction (e.g., the third direction DR3) of the base layer BL. The third part P3 of the lower encapsulation inorganic pattern LIL may extend from the second part P2 in a direction away from the partition wall opening OP-P and may be spaced apart from the partition wall PW on a cross section. That is, a portion of the lower encapsulation inorganic pattern LIL may be formed inside the partition wall opening OP-P, and another portion of the lower encapsulation inorganic pattern LIL may be formed on the partition wall PW.

Further, the lower encapsulation inorganic pattern LIL may include a first lower encapsulation inorganic pattern LIL1 and a second lower encapsulation inorganic pattern LIL2. The first lower encapsulation inorganic pattern LIL1 and the second lower encapsulation inorganic pattern LIL2 may be sequentially arranged on the cathode CE.

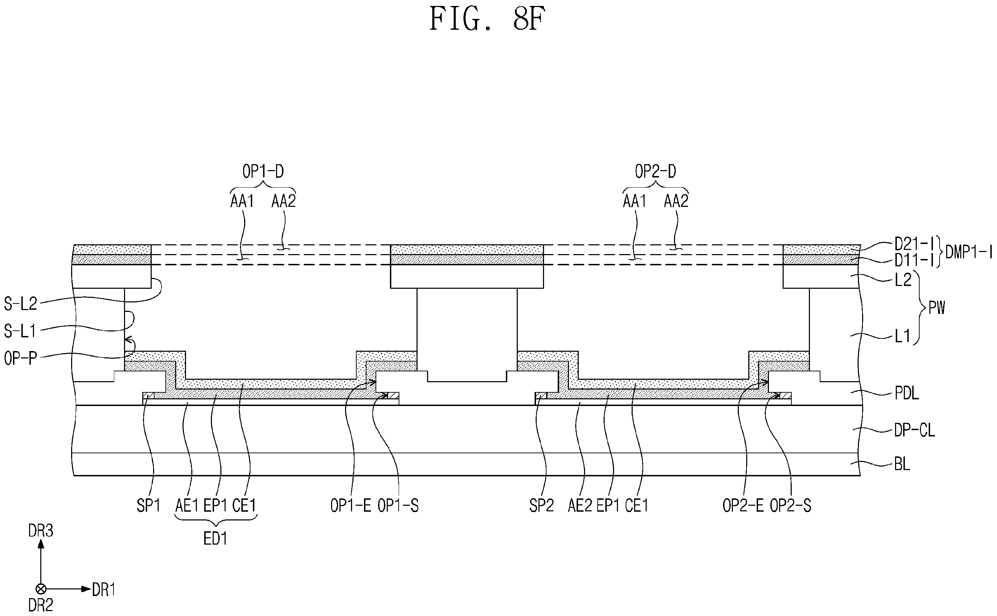

A lower organic layer BOL may be located between the lower encapsulation inorganic pattern LIL and the partition wall PW. For example, the lower organic layer BOL may be located between the third part P3 of the lower encapsulation inorganic pattern LIL and the partition wall PW on a cross section. An area in which the lower organic layer BOL is formed may be an area in which dummy layers (e.g., a first dummy layer DMP1-I, see FIG. 8F) are formed and removed during a process of manufacturing a display panel, which will be described below.

The lower organic layer BOL may include an inner part IP and a boundary part BP. The inner part IP of the lower organic layer BOL may be a part located between the third part P3 of the lower encapsulation inorganic pattern LIL and the partition wall PW. The boundary part BP of the lower organic layer BOL may be formed by surrounding the inner part IP on a plane (or in a plan view). The inner part IP and the boundary part BP may have the integral shape but may have different materials. For example, the boundary part BP may include a material obtained by changing a portion of the inner part IP by a chemical reaction.

In FIG. 5, a side surface of the lower encapsulation inorganic pattern LIL has a shape inclined at an angle (e.g., a set or predetermined angle) with respect to a side surface of the lower organic layer BOL, but embodiments according to the present disclosure are not limited to the above example. For example, the side surface of the lower encapsulation inorganic pattern LIL and the side surface of the lower organic layer BOL may be aligned with each other.

The encapsulation organic film OL may be located on the lower encapsulation inorganic pattern LIL. The encapsulation organic film OL may cover the lower encapsulation inorganic pattern LIL and provide a flat upper surface. The lower organic layer BOL may be in contact with the encapsulation organic film OL. For example, the boundary part BP of the lower organic layer BOL may be in contact with the encapsulation organic film OL.

The upper encapsulation inorganic film UIL may be located on the encapsulation organic film OL. The lower encapsulation inorganic pattern LIL and the upper encapsulation inorganic film UIL may protect the display element layer DP-OLED from moisture/oxygen, and the encapsulation organic film OL may protect the display element layer DP-OLED from foreign substances such as dust particles.

According to some embodiments of the present disclosure, the display panel DP may further include a capping pattern. The capping pattern may be located inside the partition wall opening OP-P and located on the cathode CE. The capping pattern may be patterned by the tip portion formed in the partition wall PW.

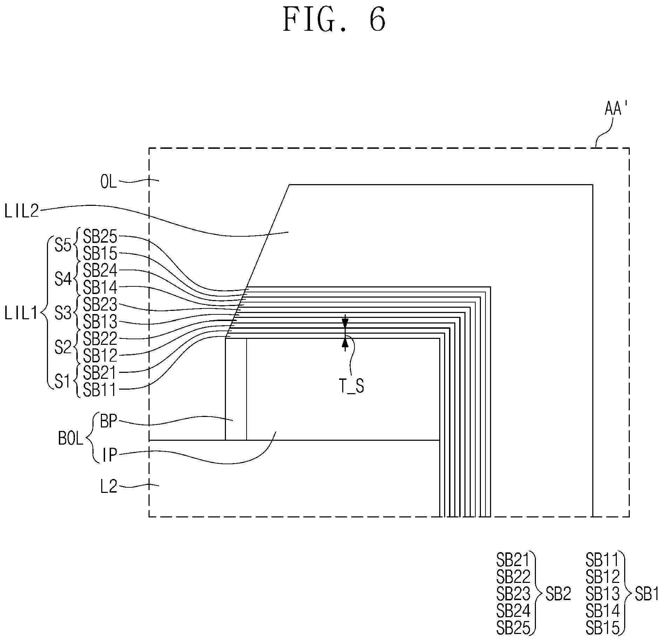

FIG. 6 is an enlarged view of the area AA' of FIG. 5.

Referring to FIGS. 5 and 6, the first lower encapsulation inorganic pattern LIL1 may include a plurality of inorganic patterns S1, S2, S3, S4, and S5 that are repeatedly laminated. Each of the plurality of inorganic patterns S1, S2, S3, S4, and S5 may include a silicon nitride (SiNx). Each of the plurality of inorganic patterns S1, S2, S3, S4, and S5 may include a first sub-pattern SB1 and a second sub-pattern SB2. The first sub-pattern SB1 may include first sub-patterns SB11, SB12, SB13, SB14, and SB15, and the second sub-pattern SB2 may include second sub-patterns SB21, SB22, SB23, SB24, and SB25. The first sub-patterns SB11, SB12, SB13, SB14, and SB15 and the second sub-patterns SB21, SB22, SB23, SB24, and SB25 may be sequentially and repeatedly laminated.

For example, the plurality of inorganic patterns S1, S2, S3, S4, and S5 may include the first inorganic pattern S1, the second inorganic pattern S2, the third inorganic pattern S3, the fourth inorganic pattern S4, and the fifth inorganic pattern S5. The first inorganic pattern S1 may include the (1-1)th sub-pattern SB11 that is the first sub-pattern SB1 and the (2-1)th sub-pattern SB21 that is the second sub-pattern SB2. The second inorganic pattern S2 may include the (1-2)th sub-pattern SB12 that is the first sub-pattern SB1 and the (2-2)th sub-pattern SB22 that is the second sub-pattern SB2. The third inorganic pattern S3 may include the (1-3)th sub-pattern SB13 that is the first sub-pattern SB1 and the (2-3)th sub-pattern SB23 that is the second sub-pattern SB2. The fourth inorganic pattern S4 may include the (1-4)th sub-pattern SB14 that is the first sub-pattern SB1 and the (2-4)th sub-pattern SB24 that is the second sub-pattern SB2. The fifth inorganic pattern S5 may include the (1-5)th sub-pattern SB15 that is the first sub-pattern SB1 and the (2-5)th sub-pattern SB25 that is the second sub-pattern SB2.

The (1-1)th sub-pattern SB11, the (2-1)th sub-pattern SB21, the (1-2)th sub-pattern SB12, the (2-2)th sub-pattern SB22, the (1-3)th sub-pattern SB13, the (2-3)th sub-pattern SB23, the (1-4)th sub-pattern SB14, the (2-4)th sub-pattern SB24, the (1-5)th sub-pattern SB15, and the (2-5)th sub-pattern SB25 may be sequentially laminated on the cathode CE. In this case, one of the first sub-patterns SB11, SB12, SB13, SB14, and SB15 and one of the second sub-patterns SB21, SB22, SB23, SB24, and SB25 may be sequentially and alternately laminated.

Each of the first sub-pattern SB1 and the second sub-pattern SB2 may include a silicon nitride (SiNx). The first sub-pattern SB1 may be richer (e.g., have a relatively greater concentration) in silicon (Si-rich) than the second sub-pattern SB2, and the second sub-pattern SB2 may be richer (e.g., have a relatively greater concentration) in nitrogen (N-rich) than the first sub-pattern SB1. That is, the first sub-pattern SB1 may be a silicon-rich (Si-rich) silicon nitride (SiNx) layer, and the second sub-pattern SB2 may be a nitrogen-rich (N-rich) silicon nitride (SiNx) layer.

A thickness T_S of one of the plurality of inorganic patterns S1, S2, S3, S4, and S5 may be 175 nm or more and 200 nm or less. The thickness T_S of each of the plurality of inorganic patterns S1, S2, S3, S4, and S5 may be substantially the same. The plurality of inorganic patterns S1, S2, S3, S4, and S5 may have distributed Bragg reflectors (DBR) characteristics. That is, the plurality of inorganic patterns S1, S2, S3, S4, and S5 may reflect a light having a specific wavelength range. For example, the plurality of inorganic patterns S1, S2, S3, S4, and S5 may reflect a light having a wavelength of 350 nm to 400 nm.

A thickness of the first sub-pattern SB1 may be the same as a thickness of the second sub-pattern SB2. However, this is illustrative, and the thickness of the first sub-pattern SB1 and the thickness of the second sub-pattern SB2 are not limited to the above example. For example, the thickness of the first sub-pattern SB1 may be smaller than or greater than the thickness of the second sub-pattern SB2.

FIG. 6 illustratively illustrates that the plurality of inorganic patterns S1, S2, S3, S4, and S5 include five inorganic patterns S1, S2, S3, S4, and S5, but embodiments according to the present disclosure are not limited to the above example. For example, the plurality of inorganic patterns may include two to four inorganic patterns or may include six or more inorganic patterns.

The second lower encapsulation inorganic pattern LIL2 may be located on the first lower encapsulation inorganic pattern LIL1. A thickness of the second lower encapsulation inorganic pattern LIL2 may be greater than a thickness of the first lower encapsulation inorganic pattern LIL1. However, embodiments according to the present disclosure are not limited to the above example, and the thickness of the second lower encapsulation inorganic pattern LIL2 may be equal to or smaller than the thickness of the first lower encapsulation inorganic pattern LIL1.

According to the present disclosure, the lower encapsulation inorganic pattern LIL may include a plurality of inorganic patterns S1, S2, S3, S4, and S5, and the plurality of inorganic patterns S1, S2, S3, S4, and S5 may include a silicon nitride (SiNx). As the plurality of inorganic patterns S1, S2, S3, S4, and S5 including a silicon nitride (SiNx) cover the partition wall PW, a phenomenon may be relatively reduced or removed in which the lower encapsulation inorganic pattern LIL is oxidized by foreign substances introduced from a side surface of the first partition wall layer L1, a lower surface of the second partition wall layer L2, and a side surface of the second partition wall layer L2.

Further, as the display panel DP includes the lower organic layer BOL located between the partition wall PW and the lower encapsulation inorganic pattern LIL, a phenomenon may be relatively reduced or removed in which foreign substances are introduced between the partition wall PW and the lower encapsulation inorganic pattern LIL. Thus, pixel defects (dart spots, pixel shrinkage, or the like) of the display panel DP, which are caused by foreign substances, may be relatively reduced or removed.

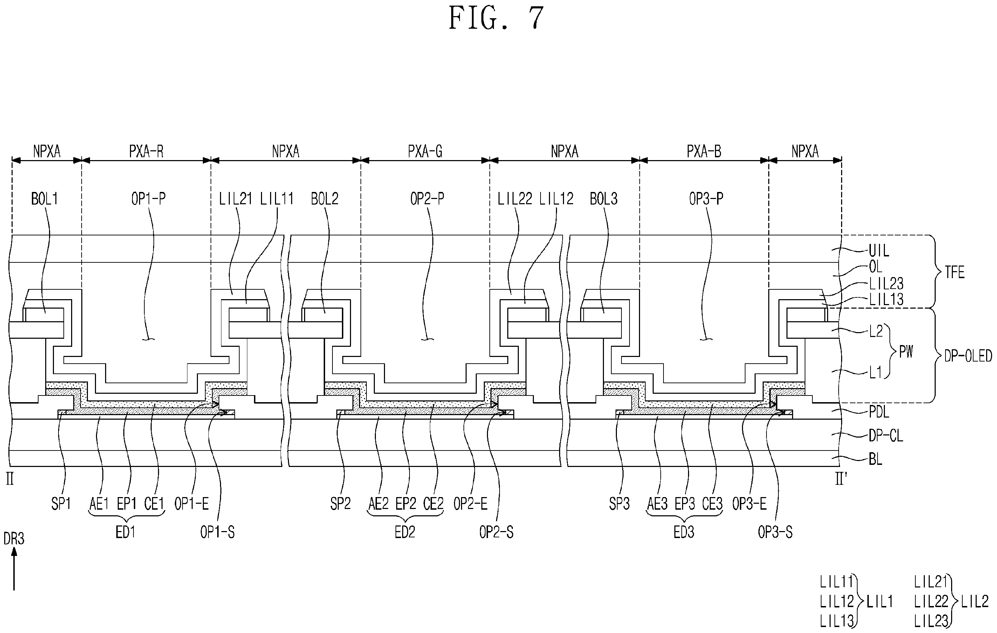

FIG. 7 is a cross-sectional view along the line II-II' of FIG. 4. FIG. 7 enlargedly illustrates one first light emitting area PXA-R, one second light emitting area PXA-G, and one third light emitting area PXA-B, and the description of the one light emitting area PXA of FIG. 5 may be equally applied to the first to third light emitting areas PXA-R, PXA-G, and PXA-B of FIG 7.

Referring to FIG. 7, the display panel DP according to some embodiments may include the base layer BL, the circuit element layer DP-CL, the display element layer DP-OLED, and the thin film encapsulation Layer TFE. The display element layer DP-OLED may include light emitting elements ED1, ED2, and ED3, sacrificial patterns SP1, SP2, and SP3, the pixel defining film PDL, and the partition wall PW.

The light emitting elements ED1, ED2, and ED3 may include the first light emitting element ED1, the second light emitting element ED2, and the third light emitting element ED3. The first light emitting element ED1 may include a first anode AE1, a first light emitting pattern EP1, and a first cathode CE1. The second light emitting element ED2 may include a second anode AE2, a second light emitting pattern EP2, and a second cathode CE2. The third light emitting element ED3 may include a third anode AE3, a third light emitting pattern EP3, and a third cathode CE3. The first to third anodes AE1, AE2, and AE3 may be provided as a plurality of patterns. According to some embodiments, the first light emitting pattern EP1 may provide red light, the second light emitting pattern EP2 may provide green light, and the third light emitting pattern EP3 may provide blue light.

First to third light emitting openings OP1-E, OP2-E, and OP3-E may be defined in the pixel defining film PDL. The first light emitting opening OP1-E may expose at least a portion of the first anode AE1. The second light emitting opening OP2-E may expose at least a portion of the second anode AE2. The third light emitting opening OP3-E may expose at least a portion of the third anode AE3. According to some embodiments, the first light emitting area PXA-R may be defined as an area of an upper surface of the first anode AE1, which is exposed by the first light emitting opening OP1-E. The second light emitting area PXA-G may be defined as an area of an upper surface of the second anode AE2, which is exposed by the second light emitting opening OP2-E. The third light emitting area PXA-B may be defined as an area of an upper surface of the third anode AE3, which is exposed by the third light emitting opening OP3-E.

The sacrificial patterns SP1, SP2, and SP3 may include the first sacrificial pattern SP1, the second sacrificial pattern SP2, and the third sacrificial pattern SP3. The first to third sacrificial patterns SP1, SP2, and SP3 may be arranged on the upper surfaces of the first to third anodes AE1, AE2, and AE3, respectively. First to third sacrificial openings OP1-S, OP2-S, and OP3-S overlapping the first to third light emitting openings OP1-E, OP2-E, and OP3-E may be defined in the first to third sacrificial patterns SP1, SP2, and SP3, respectively.

According to some embodiments, first to third partition wall openings OP1-P, OP2-P, and OP3-P respectively overlapping the first to third light emitting openings OP1-E, OP2-E, and OP3-E may be defined in the partition wall PW. Each of the first to third partition wall openings OP1-P, OP2-P, and OP3-P may include the first area A1 (see FIG. 5) and the second area A2 (see FIG. 5) described in FIG. 5. The first partition wall layer L1 may include first inner surfaces S-L1 (see FIG. 8D) defining the first areas A1 of the first to third partition wall openings OP1-P, OP2-P, and OP3-P, and the second partition wall layer L2 may include second inner surfaces S-L2 (see FIG. 8D) defining the second areas A2 of the first to third partition wall openings OP1-P, OP2-P, and OP3-P.

The first light emitting pattern EP1 and the first cathode CE1 may be arranged in the first partition wall opening OP1-P, the second light emitting pattern EP2 and the second cathode CE2 may be arranged in the second partition wall opening OP2-P, and the third light emitting pattern EP3 and the third cathode CE3 may be arranged in the third partition wall opening OP3-P.

According to some embodiments, the first to third light emitting patterns EP1, EP2, and EP3 and the first to third cathodes CE1, CE2, and CE3 may be physically separated by the second partition wall layer L2 forming the tip portion and may be formed inside the light emitting openings OP1-E, OP2-E, and OP3-E and the partition wall openings OP1-P, OP2-P, and OP3-P.

According to the present disclosure, the plurality of first light emitting patterns EP1 may be patterned and deposited in units of pixels by the tip portion defined in the partition wall PW. That is, the plurality of first light emitting patterns EP1 may be commonly formed using an open mask but may be easily divided in units of pixels by the partition wall PW.

On the other hand, when the first light emitting patterns EP1 are patterned using a fine metal mask (FMM), a support spacer protruding from the conductive partition wall to support the FMM should be provided. Further, since the FMM is spaced apart from a base surface, on which the patterning is performed, by a height of the partition wall PW and the spacer, implementation in a high resolution may be limited. Further, as the FMM is in contact with the spacer, after the patterning process for the first light emitting patterns EP1, the spacer may be damaged due to foreign substances remaining on the spacer or stamping of the FMM. Accordingly, a defective display panel may be formed.

According to some embodiments, the partition wall PW is included so that physical separation between the light emitting elements ED1, ED2, and ED3 may be easily performed. Accordingly, current leakage or driving errors between the adjacent light emitting areas PXA-R, PXA-G, and PXA-B may be prevented, and independent driving for each of the light emitting elements ED1, ED2, and ED3 may be performed.

In particular, since the plurality of first light emitting patterns EP1 are patterned without a mask in contact with an inner component inside the display area DA (see FIG. 1B), a defect rate is relatively reduced, and thus the display panel DP having relatively improved process reliability may be provided. As the patterning may be performed even when the separate support spacer protruding from the partition wall PW is not provided, areas of the light emitting areas PXA-R, PXA-G, and PXA-B may be minimized, and thus the display panel DP that easily implements a high resolution may be provided.

Further, in manufacturing a large-area display panel DP, the display panel DP may be provided in which process cost may be relatively reduced as production of a large-area mask is omitted, and process reliability may be relatively improved as the display panel DP is not affected by defects that may occur in the large-area mask. The description of the plurality of first light emitting patterns EP1 may be equally applied to the plurality of second light emitting patterns EP2 and the plurality of third light emitting patterns EP3.

The thin film encapsulation layer TFE may include the lower encapsulation inorganic patterns LIL1 and LIL2, lower organic layers BOL1, BOL2, and BOL3, the encapsulation organic film OL, and the upper encapsulation inorganic film UIL.

According to some embodiments, the lower encapsulation inorganic patterns LIL1 and LIL2 may include the first lower encapsulation inorganic pattern LIL1 and the second lower encapsulation inorganic pattern LIL2. The first lower encapsulation inorganic pattern LIL1 may include a (1-1)th lower encapsulation inorganic pattern LIL11, a (1-2)th lower encapsulation inorganic pattern LIL12, and a (1-3)th lower encapsulation inorganic pattern LIL13, and the (1-1)th lower encapsulation inorganic pattern LIL11, the (1-2)th lower encapsulation inorganic pattern LIL12, and the (1-3)th lower encapsulation inorganic pattern LIL13 may be provided in a pattern form in which the (1-1)th lower encapsulation inorganic pattern LIL11, the (1-2)th lower encapsulation inorganic pattern LIL12, and the (1-3)th lower encapsulation inorganic pattern LIL13 are spaced apart from each other. The second lower encapsulation inorganic pattern LIL2 may include a (2-1)th lower encapsulation inorganic pattern LIL21, a (2-2)th lower encapsulation inorganic pattern LIL22, and a (2-3)th lower encapsulation inorganic pattern LIL23, and the (2-1)th lower encapsulation inorganic pattern LIL21, the (2-2)th lower encapsulation inorganic pattern LIL22, and the (2-3)th lower encapsulation inorganic pattern LIL23 may be provided in a pattern form in which the (2-1)th lower encapsulation inorganic pattern LIL21, the (2-2)th lower encapsulation inorganic pattern LIL22, and the (2-3)th lower encapsulation inorganic pattern LIL23 are spaced apart from each other.

The first and second lower encapsulation inorganic patterns LIL1 and LIL2 may overlap the first to third light emitting openings OP1-E, OP2-E, and OP3-E. For example, the (1-1)th lower encapsulation inorganic pattern LIL11 and the (2-1)th lower encapsulation inorganic pattern LIL21 may overlap the first light emitting opening OP1-E, the (1-2)th lower encapsulation inorganic pattern LIL12 and the (2-2)th lower encapsulation inorganic pattern LIL22 may overlap the second light emitting opening OP2-E, and the (1-3)th lower encapsulation inorganic pattern LIL13 and the (2-3)th lower encapsulation inorganic pattern LIL23 may overlap the third light emitting opening OP3-E.

The lower organic layers BOL1, BOL2, and BOL3 may include the first lower organic layer BOL1, the second lower organic layer BOL2, and the third lower organic layer BOL3. The first lower organic layer BOL1 may be formed between the (1-1)th lower encapsulation inorganic pattern LIL11 and the partition wall PW defining the first partition wall opening OP1-P on a cross section. The second lower organic layer BOL2 may be formed between the (1-2)th lower encapsulation inorganic pattern LIL12 and the partition wall PW defining the second partition wall opening OP2-P on a cross section. The third lower organic layer BOL3 may be formed between the (1-3)th lower encapsulation inorganic pattern LIL13 and the partition wall PW defining the third partition wall opening OP3-P on a cross section.

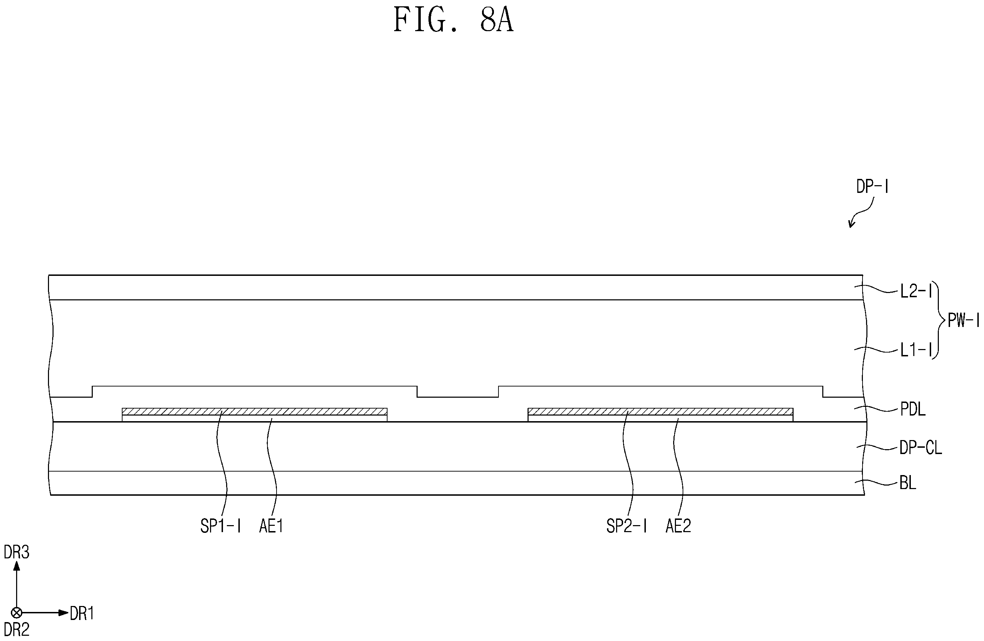

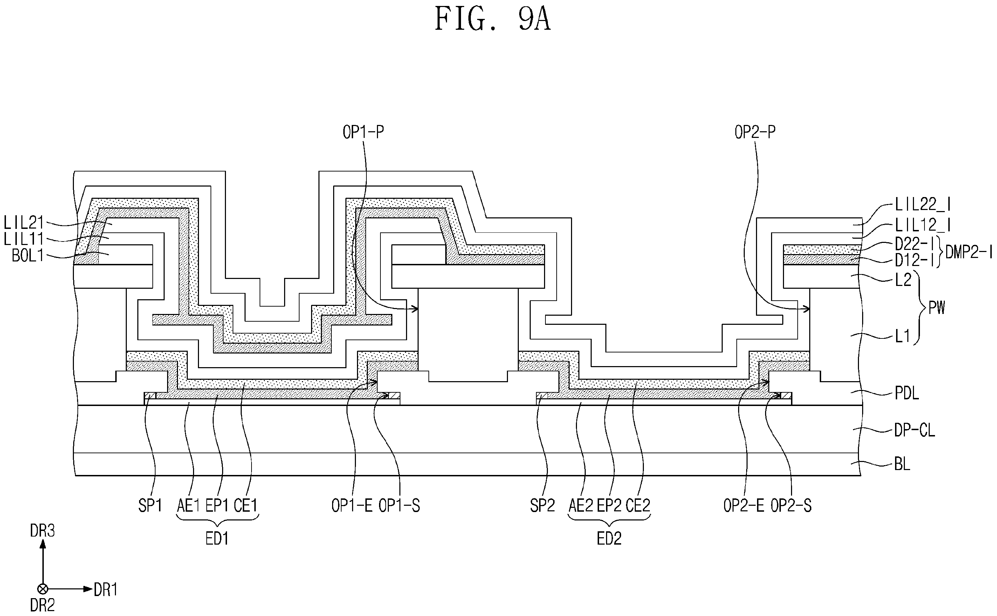

FIGS. 8A to 8N are cross-sectional views or schematic views illustrating some of operations of a method of manufacturing the display panel according to some embodiments of the present disclosure. FIGS. 9A to 9E are cross-sectional views illustrating some of operations of the method of manufacturing the display panel according to some embodiments of the present disclosure. In description of FIGS. 8A to 9E, the same/similar reference numerals will be used for the same/similar components with reference to FIGS. 1 to 7, and duplicated descriptions thereof will be omitted.

A method of manufacturing a display panel according to the present disclosure may include an operation of providing a preliminary display panel including a base layer, a pixel defining film located on the base layer, a first preliminary partition wall layer located on the pixel defining film, and a second preliminary partition wall layer located on the first preliminary partition wall layer, an operation of etching the first preliminary partition wall layer and the second preliminary partition wall layer to form a first partition wall layer and a second partition wall layer in which a partition wall opening is defined, an operation of forming a light emitting pattern and a cathode within the partition wall opening, an operation of forming a lower encapsulation inorganic pattern on the cathode, and an operation of forming a lower organic layer between the second partition wall layer and the lower encapsulation inorganic pattern.

Hereinafter, a method of forming the two light emitting elements ED1 and ED2, the lower encapsulation inorganic patterns LIL11, LIL12, LIL21, and LIL22 that cover the light emitting elements ED1 and ED2, the lower organic layers BOL1 and BOL2, the encapsulation organic film OL, and the upper encapsulation inorganic film UIL will be described through FIGS. 8A to 9E. The display panel DP formed through FIGS. 8A to 9E may correspond to a portion of the display panel DP of FIG. 7.

Referring to FIG. 8A, the method of manufacturing a display panel according to some embodiments may include an operation of providing a preliminary display panel DP-I. The preliminary display panel DP-I according to some embodiments may include the base layer BL, the circuit element layer DP-CL, the first and second anodes AE1 and AE2, first and second sacrificial layers SP1-I and SP2-I, the pixel defining film PDL, a first preliminary partition wall layer L1-I, and a second preliminary partition wall layer L2-I.

The circuit element layer DP-CL may be formed by a general method of manufacturing a circuit element, in which an insulating layer, a semiconductor layer, and a conductive layer are formed through a coating method or a deposition method, the insulating layer, the semiconductor layer, and the conductive layer are selectively patterned by a photolithography and etching process, and a semiconductor pattern, a conductive pattern, a signal line or the like are formed.

The first anode AE1 and the first sacrificial layer SP1-I may be formed through the same patterning process, and the second anode AE2 and the second sacrificial layer SP2-I may be formed through the same patterning process. The pixel defining film PDL may be located on the base layer BL. The pixel defining film PDL may cover all the first and second anodes AE1 and AE2 and the first and second sacrificial layers SP1-I and SP2-I.

The first preliminary partition wall layer L1-I may be located on the pixel defining film PDL. The first preliminary partition wall layer L1-I may be formed through a process of depositing a conductive material. The second preliminary partition wall layer L2-I may be located on the first preliminary partition wall layer L1-I. The second preliminary partition wall layer L2-I may be also formed through a process of depositing a conductive material. According to some embodiments, each of the first preliminary partition wall layer L1-I and the second preliminary partition wall layer L2-I may include a conductive material. For example, the conductive material may include a metal, a TCO, or a combination thereof. For example, the metal includes gold (Au), silver (Ag), aluminum (Al), magnesium (Mg), lithium (Li), molybdenum (Mo), titanium (Ti), copper (Cu), or alloys thereof. The TCO may include an indium tin oxide (ITO), an indium zinc oxide (IZO), a zinc oxide, an indium oxide, an indium gallium oxide, an indium gallium zinc oxide (IGZO) or an aluminum zinc oxide. However, the materials of the first preliminary partition wall layer L1-I and the second preliminary partition wall layer L2-I are not limited thereto. The first preliminary partition wall layer L1-I and the second preliminary partition wall layer L2-I may form a preliminary partition wall PW-I.

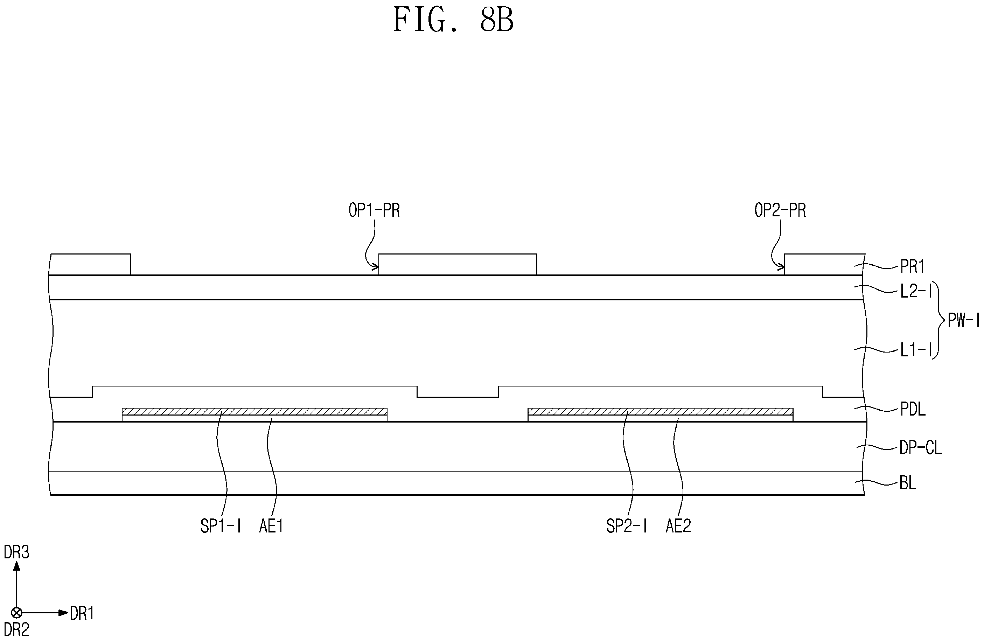

Thereafter, Referring to FIG. 8B, the method of manufacturing a display panel according to some embodiments may include an operation of forming a first photoresist layer PR1 on the preliminary partition wall PW-I. The first photoresist layer PR1 may be formed by forming a preliminary photoresist layer on the preliminary partition wall PW-I and then patterning the preliminary photoresist layer using a photo mask. Through the patterning process, a first photo opening OP1-PR overlapping the first anode AE1 and a second photo opening OP2-PR overlapping the second anode AE2 may be formed in the first photoresist layer PR1.

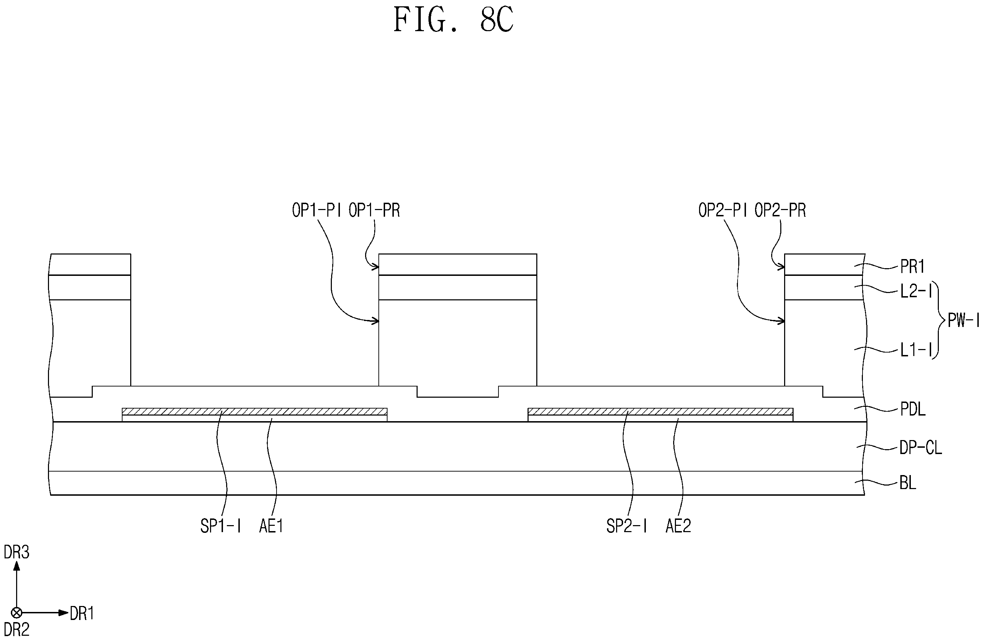

Thereafter, referring to FIGS. 8C and 8D, the method of manufacturing a display panel according to some embodiments may include an operation of forming the first partition wall layer L1 and the second partition wall layer L2, in which the partition wall openings OP1-P and OP2-P are defined, by etching the first preliminary partition wall layer L1-I and the second preliminary partition wall layer L2-I so that the partition wall PW is formed from the preliminary partition wall PW-I (see FIG. 8B).

First, as illustrated in FIG. 8C, the primary etching of the first preliminary partition wall layer L1-I and the second preliminary partition wall layer L2-I may include an operation of forming preliminary partition wall openings OP1-PI and OP2-PI in the preliminary partition wall PW-I by using the first photoresist layer PR1 as a mask and dry-etching the first preliminary partition wall layer L1-I and the second preliminary partition wall layer L2-I. The preliminary partition wall openings OP1-PI and OP2-PI may include the first preliminary partition wall opening OP1-PI and the second preliminary partition wall opening OP2-PI. The first preliminary partition wall opening OP1-PI may be formed to overlap the first anode AE1, and the second preliminary partition wall opening OP2-PI may be formed to overlap the second anode AE2.

A primary dry etching process according to some embodiments may be performed in an etching environment in which an etching selection ratio between the first preliminary partition wall layer L1-I and the second preliminary partition wall layer L2-I is substantially the same. Accordingly, an inner surface of the first preliminary partition wall layer L1-I and an inner surface of the second preliminary partition wall layer L2-I, which define the preliminary partition wall openings OP1-PI and OP2-PI, may be substantially aligned with each other.

Thereafter, as illustrated in FIG. 8D, an operation of secondarily etching the first preliminary partition wall layer L1-I (see FIG. 8C) may include an operation of forming the partition wall openings OP1-P and OP2-P from the preliminary partition wall openings OP1-PI and OP2-PI (see FIG. 8C) using the first photoresist layer PR1 as a mask and wet etching the first preliminary partition wall layer L1-I. The partition wall openings OP1-P and OP2-P may include the first partition wall opening OP1-P and the second partition wall opening OP2-P. The first partition wall opening OP1-P may be formed to overlap the first anode AE1, and the second partition wall opening OP2-P may be formed to overlap the second anode AE2.

Each of the partition wall openings OP1-P and OP2-P may include the first area A1 and the second area A2 sequentially formed in the thickness direction (i.e., the third direction DR3). The first partition wall layer L1 may include the first inner surface S-L1 defining the first area A1 of the partition wall openings OP1-P and OP2-P, and the second partition wall layer L2 may include the second inner surface S-L2 defining the second area A2.

A secondary wet etching process according to some embodiments may be performed in an environment in which the etching selection ratio between the first preliminary partition wall layer L1-I and the second preliminary partition wall layer L2-I is large. Accordingly, an inner surface of the partition wall PW defining the partition wall openings OP1-P and OP2-P may have an undercut shape on a cross section. For example, as an etch rate of the first partition wall layer L1 with respect to an etching solution is greater than an etch rate of the second partition wall layer L2 with respect to the etching solution, the first partition wall layer L1 may be mainly etched. Accordingly, the first inner surface S-L1 of the first partition wall layer L1 may be formed to be more recessed inward than the second inner surface S-L2 of the second partition wall layer L2. The tip portion may be formed in the partition wall PW by a portion of the second partition wall layer L2 protruding further from the first partition wall layer L1.

According to some embodiments of the present disclosure, the operation of forming the partition wall opening OP-P may include an operation of simultaneously forming the partition wall openings OP1-P, OP2-P, and OP3-P (see FIG. 7). For convenience of description, FIGS. 8C and 8D illustratively illustrate that the partition wall openings OP1-P and OP2-P corresponding to the first and second light emitting areas PXA-R and PXA-G (see FIG. 4) are formed. However, embodiments according to the present disclosure are not limited to the above example, and according to some embodiments of the present disclosure, the operation of forming the partition wall opening OP-P may include an operation of forming only the first partition wall opening OP1-P corresponding to the first light emitting area PXA-R. For example, after the first partition wall opening OP1-P corresponding to the first light emitting area PXA-R is formed and the first light emitting element is formed through a subsequent process, the second partition wall opening OP2-P corresponding to the second light emitting area PXA-G may be formed. Further, through a subsequent process, the second light emitting element may be formed, and the third partition wall opening OP3-P corresponding to the third light emitting area PXA-B may be formed.

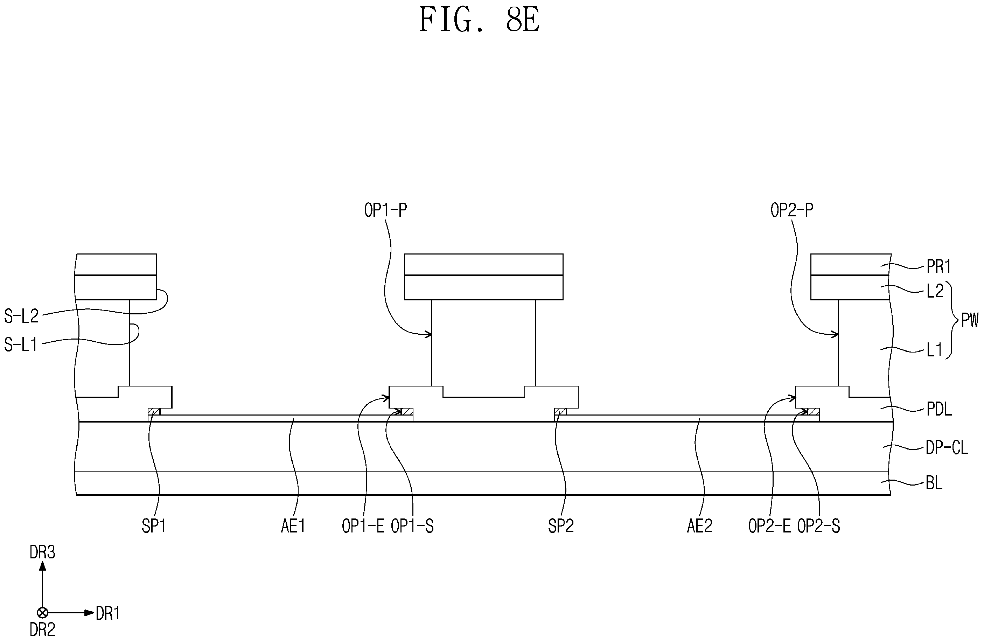

Thereafter, referring to FIG. 8E, the method of manufacturing a display panel according to some embodiments may include an operation of etching the pixel defining film PDL and an operation of etching the first and second sacrificial layers SP1-I and SP2-I (see FIG. 8D). The etching of the pixel defining film PDL may be performed in a dry etching method, and the etching may be performed using the first photoresist layer PR1 and the partition wall PW (e.g., the second partition wall layer L2) as a mask. The first and second light emitting openings OP1-E and OP2-E corresponding to the first and second partition wall openings OP1-P and OP2-P respectively may be formed in the pixel defining film PDL.

The etching of the sacrificial layers SP1-I and SP2-I may be performed in a wet etching method, and the etching may be performed using the first photoresist layer PR1 and the partition wall PW (e.g., the second partition wall layer L2) as a mask. The sacrificial openings OP1-S and OP2-S overlapping the light emitting openings OP1-E and OP2-E may be formed in the sacrificial patterns SP1 and SP2 formed by etching the sacrificial layers SP1-I and SP2-I. The sacrificial openings OP1-S and OP2-S may include the first sacrificial opening OP1-S overlapping the first light emitting opening OP1-E and the second sacrificial opening OP2-S overlapping the second light emitting opening OP2-E. At least portions of the anodes AE1 and AE2 may be exposed from the sacrificial patterns SP1 and SP2 and the pixel defining film PDL by the sacrificial openings OP1-S and OP2-S and the light emitting openings OP1-E and OP2-E.

The etching process of the sacrificial patterns SP1 and SP2 may be performed in an environment in which an etching selection ratio between the sacrificial patterns SP1 and SP2 and the anodes AE1 and AE2 is high, and therefore, the anodes AE1 and AE2 may be prevented from being etched together. That is, as the sacrificial patterns SP1 and SP2 having a higher etch rate than that of the anodes AE1 and AE2 are arranged between the pixel defining film PDL and the anodes AE1 and AE2, the anodes AE1 and AE2 may be prevented from being etched together and damaged during the etching process.

Thereafter, referring to FIG. 8F, the method of manufacturing a display panel according to some embodiments may include an operation of forming the first light emitting pattern EP1 and the first cathode CE1 inside the partition wall openings OP1-P and OP2-P after removing the first photoresist layer PR1 (see FIG. 8E).

The operation of the forming the first light emitting pattern EP1 may be performed through a deposition process. According to some embodiments, the operation of forming the first light emitting pattern EP1 may include a thermal evaporation process. The first light emitting pattern EP1 may be formed on the anodes AE1 and AE2. The first light emitting pattern EP1 may be separated by the tip portion formed in the partition wall PW and located inside the light emitting openings OP1-E and OP2-E and the partition wall openings OP1-P and OP2-P.

In the operation of forming the first light emitting pattern EP1, a (1-1)th dummy layer D11-I spaced apart from the first light emitting pattern EP1 may be formed on the partition wall PW together. The (1-1)th dummy layer D11-I may include an organic material. For example, the (1-1)th dummy layer D11-I may include the same material as the first light emitting pattern EP1. The (1-1)th dummy layer D11-I together with the first light emitting pattern EP1 may be simultaneously formed through one process and formed separately from the first light emitting pattern EP1 by the undercut shape of the partition wall PW.

The operation of forming the first cathode CE1 may be performed through a deposition process. According to some embodiments, the operation of forming the first cathode CE1 may include a sputtering process. The first cathode CE1 may be formed on the first light emitting pattern EP1. The first cathode CE1 may be separated by the tip portion formed in the partition wall PW and located inside the partition wall openings OP1-P and OP2-P. The first cathode CE1 may be provided at a higher input angle than that of the first light emitting pattern EP1, and the first cathode CE1 may be formed in contact with the first inner surface S-L1 of the first partition wall layer L1. The first anode AE1, the first light emitting pattern EP1, and the first cathode CE1 may constitute the first light emitting element ED1.

In the operation of forming the first cathode CE1, a (2-1)th dummy layer D21-I spaced apart from the first cathode CE1 may be formed on the partition wall PW together. The (2-1)th dummy layer D21-I may include a conductive material. For example, the first cathode CE1 and the (2-1)th dummy layer D21-I may include the same material. The (2-1)th dummy layer D21-I together with the first cathode CE1 may be simultaneously formed through one process and formed separately from the first cathode CE1 by the undercut shape of the partition wall PW.

The (1-1)th dummy layer D11-I and the (2-1)th dummy layer D21-I may be sequentially laminated in the third direction DR3 on an upper surface of the partition wall PW. The (1-1)th dummy layer D11-I and the (2-1)th dummy layer D21-I may form a first dummy layer DMP1-I, and dummy openings OP1-D and OP2-D may be formed in the first dummy layer DMP1-I. Each of the dummy openings OP1-D and OP2-D may include a first area AA1 and a second area AA2 sequentially formed in the thickness direction (i.e., the third direction DR3). The first area AA1 of the dummy openings OP1-D and OP2-D may be defined by an inner surface of the (1-1)th dummy layer D11-I, and the second area AA2 thereof may be defined by an inner surface of the (2-1)th dummy layer D21-I.

According to some embodiments of the present disclosure, the method of manufacturing a display panel may further include an operation of forming the capping pattern. The operation of forming the capping pattern may include a thermal evaporation process. The capping pattern may be formed on the first cathode CE1. In the operation of forming the capping pattern, the capping pattern may be separated by the tip portion formed in the partition wall PW and located inside the partition wall openings OP1-P and OP2-P.

In the operation of forming the capping pattern, a (3-1)th dummy layer spaced apart from the capping pattern may be formed together on the partition wall PW. The (3-1)th dummy layer may include a conductive material. For example, the (3-1)th dummy layer may include the same material as that of the capping pattern. The (3-1)th dummy layer together with the capping pattern may be simultaneously formed through one process and may be formed separately from the capping pattern by the undercut shape of the partition wall PW. In this case, the first dummy layer DMP1-I may include the (1-1)th dummy layer D11-I, the (2-1)th dummy layer D21-I, and the (3-1)th dummy layer.

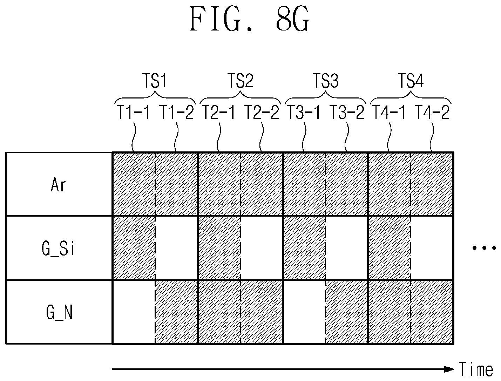

Thereafter, referring to FIGS. 8G to 8K, the method of manufacturing a display panel according to some embodiments may include an operation of forming the lower encapsulation inorganic patterns LIL11 and LIL21 on the first cathode CE1. The operation of forming the lower encapsulation inorganic patterns LIL11 and LIL21 may include an operation of depositing a (1-1)th lower encapsulation inorganic layer LIL11_I on the first cathode CE1, an operation of depositing a (2-1)th lower encapsulation inorganic layer LIL21_I on the (1-1)th lower encapsulation inorganic layer LlL 11_1, and an operation of etching the (1-1)th lower encapsulation inorganic layer LIL11_I and the (2-1)th lower encapsulation inorganic layer LIL21_I to form the (1-1)th lower encapsulation inorganic pattern LIL11 and the (2-1)th lower encapsulation inorganic pattern LIL21.

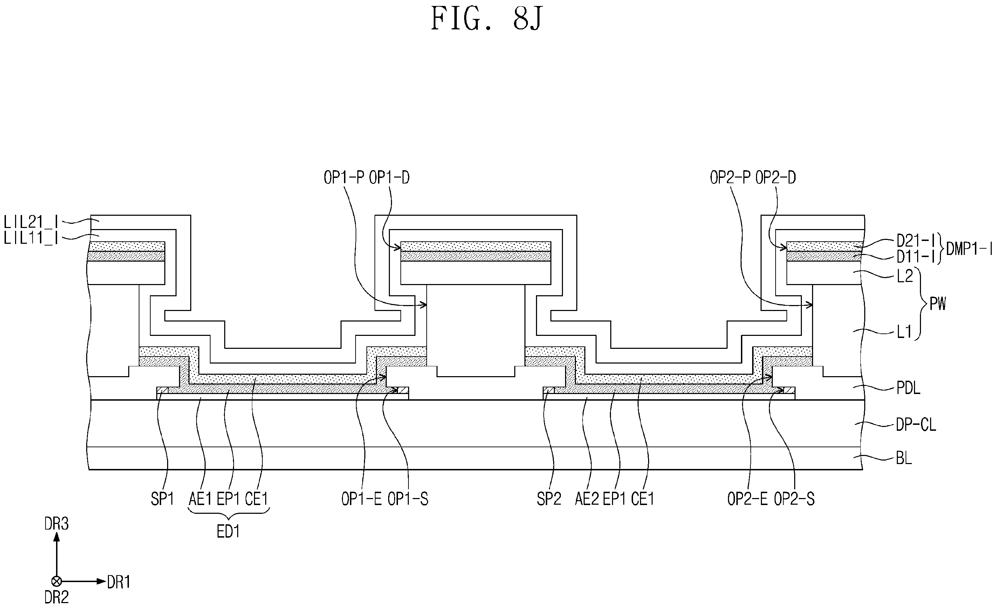

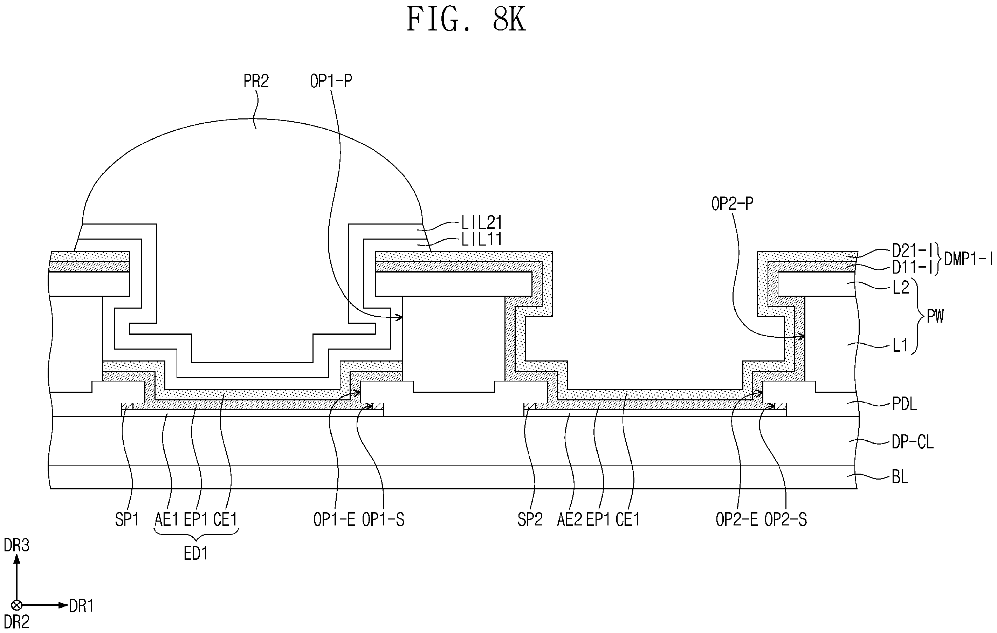

Hereinafter, the operation of depositing the (1-1)th lower encapsulation inorganic layer LIL11_I is described through FIGS. 8G to 8I, the operation of depositing the (2-1)th lower encapsulation inorganic layer LIL21_I is described through FIG. 8J, and the operation of forming the (1-1)th and (2-1)th lower encapsulation inorganic patterns LIL11 and LIL21 is described through FIG. 8K.

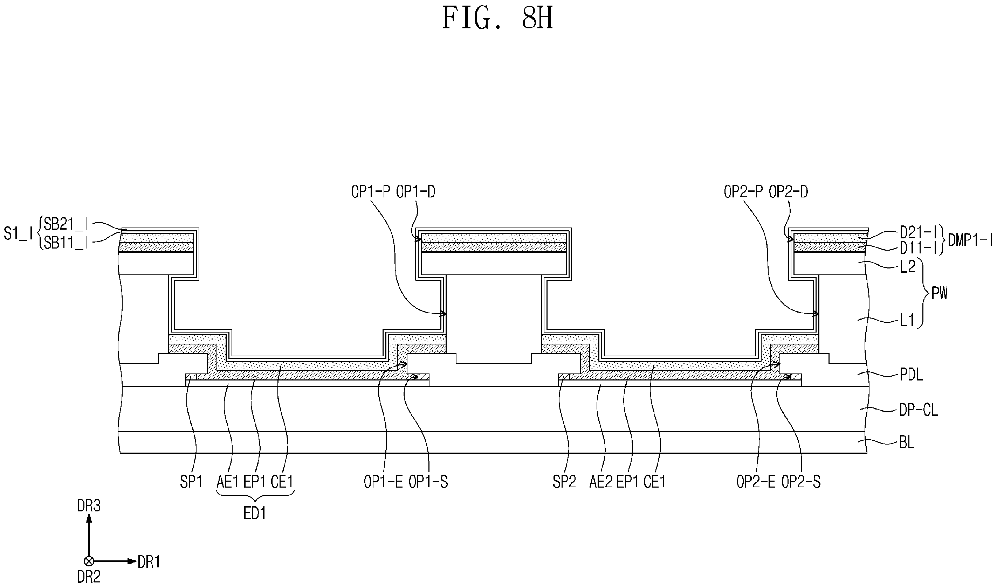

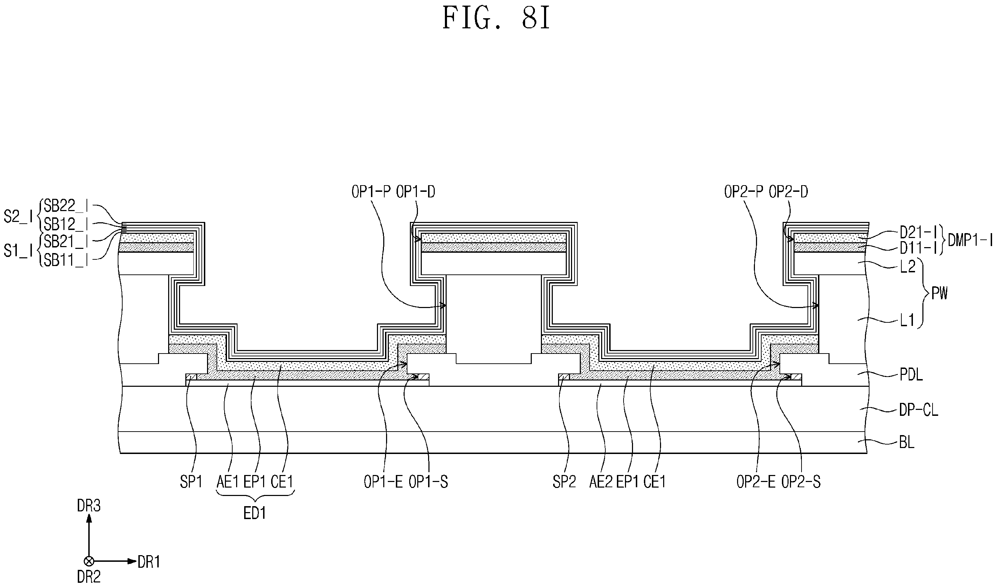

FIG. 8G is a schematic view illustrating gases Ar, G_Si, and G_N injected over time in the process of depositing the (1-1)th lower encapsulation inorganic layer LIL11_I. The process of depositing the (1-1)th lower encapsulation inorganic layer LIL11_I may be a process of forming a thin film on a substrate (e.g., the preliminary display panel DP-I (see FIG. 8A) on which the partition wall PW is formed) by injecting reaction gases. FIG. 8G illustratively illustrates a first reaction operation TS1, a second reaction operation TS2, a third reaction operation TS3, and a fourth reaction operation TS4. The first reaction operation TS1 may correspond to an operation of depositing a (1-1)th sub layer SB11_I (see FIG. 8H), which will be described below, and the second reaction operation TS2 may correspond to an operation of depositing a (2-1)th sub layer SB21_I (see FIG. 8H). The third reaction operation TS3 may correspond to an operation of depositing a (1-2)th sub layer SB12_I (see FIG. 8I), and the fourth reaction operation TS4 may correspond to an operation of depositing a (2-2)th sub layer SB22_I (see FIG. 8I).

The third reaction operation TS3 and the fourth reaction operation TS4 may be substantially the same as the first reaction operation TS1 and the second reaction operation TS2, respectively. The third reaction operation TS3 and the first reaction operation TS1 may be substantially the same, and the fourth reaction operation TS4 and the second reaction operation TS2 may be substantially the same. That is, the process of depositing the (1-1)th lower encapsulation inorganic layer LIL11_I may be a process in which the first reaction operation TS1 and the second reaction operation TS2 are repeated.

First, referring to FIGS. 8G and 8H, the operation of depositing the (1-1)th lower encapsulation inorganic layer LIL11_I on the first cathode CE1 may include an operation of depositing the (1-1)th sub layer SB11_I on the first cathode CE1, and an operation of depositing the (2-1)th sub layer SB21_I on the (1-1)th sub layer SB11_I, wherein the (1-1)th sub layer SB11_I and the (2-1)th sub layer SB21_I form a first inorganic layer S1_I.

The operation of depositing the (1-1)th sub layer SB11_I on the first cathode CE1 may include an operation of inputting a gas G_Si containing silicon and an argon gas Ar and an operation of inputting a gas G_N containing nitrogen and the argon gas Ar. For example, the gas G_Si containing silicon may be silane (SiH4), and the gas G_N containing nitrogen may be ammonia (NH3).

For example, the first reaction operation TS1 may include an initial operation T1-1 and a post operation T1-2. After the initial operation T1-1 is performed, the post operation T1-2 may be performed. The initial operation T1-1 of the first reaction operation TS1 may be an operation of inputting the gas G_Si containing silicon and the argon gas Ar. Amorphous silicon may be formed on the first cathode CE1 by the initial operation T1-1. The post operation T1-2 of the first reaction operation TS1 may be an operation of inputting the gas G_N containing nitrogen and the argon gas Ar. The amorphous silicon formed in the initial operation T1-1 may be nitrided by the post operation T1-2. As a result, the (1-1)th sub layer SB11_I may be formed on the first cathode CE1, and the (1-1)th sub layer SB11_I may be a Si-rich silicon nitride (SiNx) layer.

The operation of depositing the (2-1)th sub layer SB21_I on the (1-1)th sub layer SB11_I may include an operation of inputting the gas G_Si containing silicon, the gas G_N containing nitrogen, and the argon gas Ar and an operation of inputting the gas G_N containing nitrogen and the argon gas Ar. For example, the gas G_Si containing silicon may be silane (SiH4), and the gas G_N containing nitrogen may be ammonia (NH3).

For example, the second reaction operation TS2 may include an initial operation T2-1 and a post operation T2-2. After the initial operation T2-1 is performed, the post operation T2-2 may be performed. The initial operation T2-1 of the second reaction operation TS2 may be an operation of inputting the gas G_Si containing silicon, the gas G_N containing nitrogen, and the argon gas Ar. The silicon nitride (SiNx) may be formed on the (1-1)th sub layer SB11_I by the initial operation T2-1. The post operation T2-2 of the second reaction operation TS2 may be an operation of inputting the gas G_N containing nitrogen and the argon gas Ar. The silicon nitride (SiNx) formed in the initial operation T2-1 may be nitrided by the post operation T2-2. As a result, the (2-1)th sub layer SB21_I may be formed on the (1-1)th sub layer SB11_I, and the (2-1)th sub layer SB21_I may be a N-rich silicon nitride (SiNx) layer.

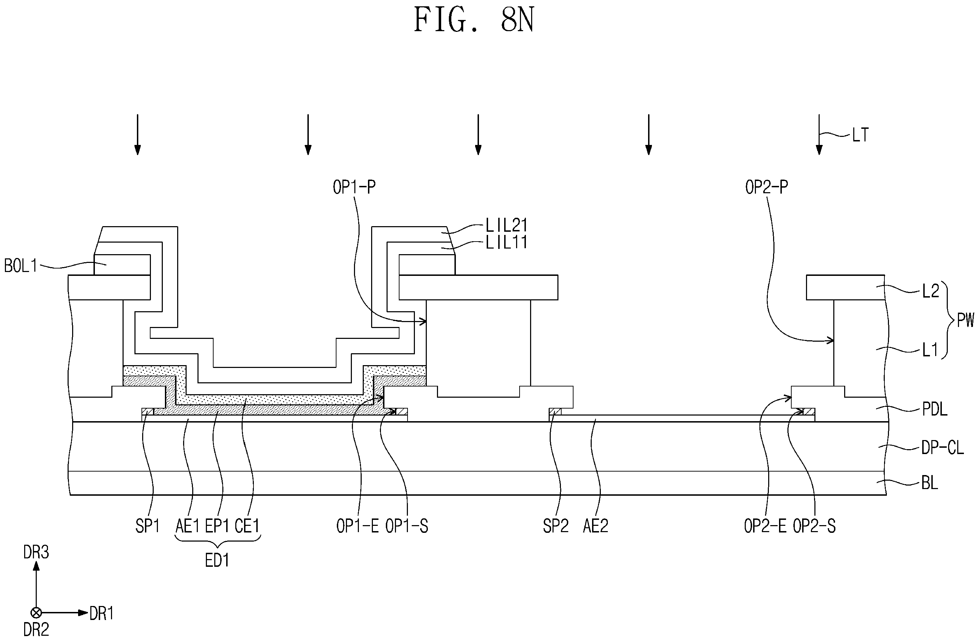

The (1-1)th sub layer SB11_I and the (2-1)th sub layer SB21_I may form the first inorganic layer S1_I. A thickness of the first inorganic layer S1_I may be a half of a wavelength of a light LT irradiated toward a preliminary lower organic layer BOL-I in FIG. 8N.

First, referring to FIGS. 8G and 8I, the operation of depositing the (1-1)th lower encapsulation inorganic layer LIL11_I on the first cathode CE1 may include an operation of depositing the (1-2)th sub layer SB12_I on the first inorganic layer S1_I, and an operation of depositing the (2-2)th sub layer SB22_I on the (1-2)th sub layer SB12_I, wherein the (1-2)th sub layer SB12_I and the (2-2)th sub layer SB22_I form a second inorganic layer S2_I.

The operation of depositing the (1-2)th sub layer SB12_I on the first inorganic layer S1_I may include an operation of inputting the gas G_Si containing silicon and the argon gas Ar and an operation of inputting the gas G_N containing nitrogen and the argon gas Ar. For example, the gas G_Si containing silicon may be silane (SiH4), and the gas G_N containing nitrogen may be ammonia (NH3).

For example, the third reaction operation TS3 may include an initial operation T3-1 and a post operation T3-2. After the initial operation T3-1 is performed, the post operation T3-2 may be performed. The initial operation T3-1 of the third reaction operation TS3 may be an operation of inputting the gas G_Si containing silicon and the argon gas Ar. Amorphous silicon may be formed on the (2-1)th sub layer SB21_I by the initial operation T3-1. The post operation T3-2 of the third reaction operation TS3 may be an operation of inputting the gas G_N containing nitrogen and the argon gas Ar. The amorphous silicon formed in the initial operation T3-1 may be nitrided by the post operation T3-2. As a result, the (1-2)th sub layer SB12_I may be formed on the first inorganic layer S1_I, and the (1-2)th sub layer SB12_I may be a Si-rich silicon nitride (SiNx) layer.

The operation of depositing the (2-2)th sub layer SB22_I on the (1-2)th sub layer SB12_I may include an operation of inputting the gas G_Si containing silicon, the gas G_N containing nitrogen, and the argon gas Ar and an operation of inputting the gas G_N containing nitrogen and the argon gas Ar. For example, the gas G_Si containing silicon may be silane (SiH4), and the gas G_N containing nitrogen may be ammonia (NH3).

For example, the fourth reaction operation TS4 may include an initial operation T4-1 and a post operation T4-2. After the initial operation T4-1 is performed, the post operation T4-2 may be performed. The initial operation T4-1 of the fourth reaction operation TS4 may be an operation of inputting the gas G_Si containing silicon, the gas G_N containing nitrogen, and the argon gas Ar. The silicon nitride (SiNx) may be formed on the (1-2)th sub layer SB12_I by the initial operation T4-1. The post operation T4-2 of the fourth reaction operation TS4 may be an operation of inputting the gas G_N containing nitrogen and the argon gas Ar. The silicon nitride (SiNx) formed in the initial operation T4-1 may be nitrided by the post operation T4-2. As a result, the (2-2)th sub layer SB22_I may be formed on the (1-2)th sub layer SB12_I, and the (2-2)th sub layer SB22_I may be a N-rich silicon nitride (SiNx) layer.

The (1-2)th sub layer SB12_I and the (2-2)th sub layer SB22_I may form the second inorganic layer S2_I. A thickness of the second inorganic layer S2_I may be the half of the wavelength of the light LT irradiated toward the preliminary lower organic layer BOL-I in FIG. 8N.

The (1-1)th sub layer SB11_I of the first inorganic layer S1_I and the (1-2)th sub layer SB12_I of a second inorganic layer S2_I may refer to first sub layers SB11_I and SB12_I, and the (2-1)th sub layer SB21_I of the first inorganic layer S1_I and the (2-2)th sub layer SB22_I of the second inorganic layer S2_I may refer to second sub layers SB21_I and SB22_I. Each of the first sub layers SB11_I and SB12_I and the second sub layers SB21_I and SB22_I may include a silicon nitride (SiNx). The first sub layers SB11_I and SB12_I may be richer (e.g., have a relatively greater concentration) in silicon than the second sub layers SB21_I and SB22_I, and the second sub layers SB21_I and SB22_I may be richer (e.g., have a relatively greater concentration) in nitrogen than the first sub layers SB11_I and SB12_I.

FIGS. 8G to 8I illustratively illustrate that two inorganic layers S1_I and S2_I are deposited, but embodiments according to the present disclosure are not limited thereto. For example, the method of manufacturing a display panel according to the present disclosure may include an operation of depositing three or more inorganic layers. For reference, FIG. 6 illustrates the display panel DP (see FIG. 5) including the first to fifth inorganic patterns S1, S2, S3, S4, and S5 obtained by depositing and then etching five inorganic layers.

Thereafter, referring to FIG. 8J, the method of manufacturing a display panel according to the present disclosure may include an operation of depositing the (2-1)th lower encapsulation inorganic layer LIL21_I on the (1-1)th lower encapsulation inorganic layer LIL11_I. The first inorganic layer S1_I and the second inorganic layer S2_I shown in FIG. 8I may form the (1-1)th lower encapsulation inorganic layer LIL11_I. The (1-1)th lower encapsulation inorganic layer LIL11_I may include the plurality of inorganic layers S1_I and S2_I. The plurality of inorganic layers S1_I and S2_I may have DBR characteristics. That is, the plurality of inorganic layers S1_I and S2_I may reflect a light having a specific wavelength range.

The (2-1)th lower encapsulation inorganic layer LIL21_I may be formed through a deposition process. According to some embodiments, the (2-1)th lower encapsulation inorganic layer LIL21_I may be formed through a chemical vapor deposition (CVD) process. The (2-1)th lower encapsulation inorganic layer LIL21_I may be formed to cover the (1-1)th lower encapsulation inorganic layer LIL11_I.

Thereafter, referring to FIG. 8K, the method of manufacturing a display panel according to the present disclosure may include an operation of forming a second photoresist layer PR2 and an operation of forming the (1-1)th and (2-1)th lower encapsulation inorganic patterns LIL11 and LIL21.

In the operation of forming the second photoresist layer PR2, the second photoresist layer PR2 may be formed by forming the preliminary photoresist layer, and then patterning the preliminary photoresist layer using a photo mask. Through the patterning process, the second photoresist layer PR2 may be formed in a pattern form corresponding to the first light emitting opening OP1-E.

In the operation of forming the (1-1)th and (2-1)th lower encapsulation inorganic patterns LIL11 and LIL21, the (1-1)th lower encapsulation inorganic layer LIL11_I and the (2-1)th lower encapsulation inorganic layer LIL21_I are dry-etched and are patterned to remove a portion overlapping a remaining anode (e.g., the second anode AE2) except for the corresponding first anode AE1 among the (1-1)th and (2-1)th lower encapsulation inorganic layers LIL11_I and LIL21_I. The (1-1)th and (2-1)th lower encapsulation inorganic patterns LIL11 and LIL21 overlapping the corresponding first light emitting opening OP1-E may be formed from the patterned (1-1)th and (2-1)th lower encapsulation inorganic layers LIL11_I and LIL21_I.

FIG. 8K illustratively illustrates the (1-1)th and (2-1)th lower encapsulation inorganic patterns LIL11 and LIL21 having inclined side surfaces, but embodiments according to the present disclosure are not limited thereto. For example, the side surfaces of the (1-1)th and (2-1)th lower encapsulation inorganic patterns LIL11 and LIL21 may be vertically aligned.

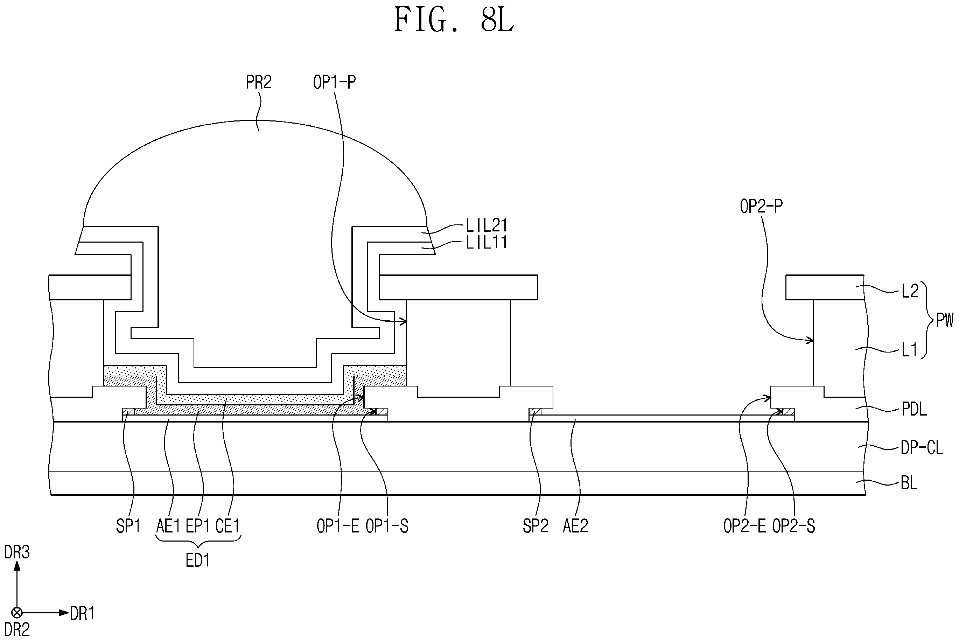

Thereafter, referring to FIG. 8L, the method of manufacturing a display panel according to the present disclosure may include an operation of removing the first dummy layers DMP1-I (see FIG. 8K), and the first light emitting pattern EP1 (see FIG. 8K) and the first cathode CE1 (see FIG. 8K) formed inside the second partition wall opening OP2-P.

In the operation of removing the first dummy layers DMP1-I and the first light emitting pattern EP1 and the first cathode CE1 formed inside the second partition wall opening OP2-P, the first dummy layers DMP1-I formed on the partition wall PW and the first light emitting pattern EP1 and the first cathode CE1 formed in the second partition wall opening OP2-P may be removed through wet etching.

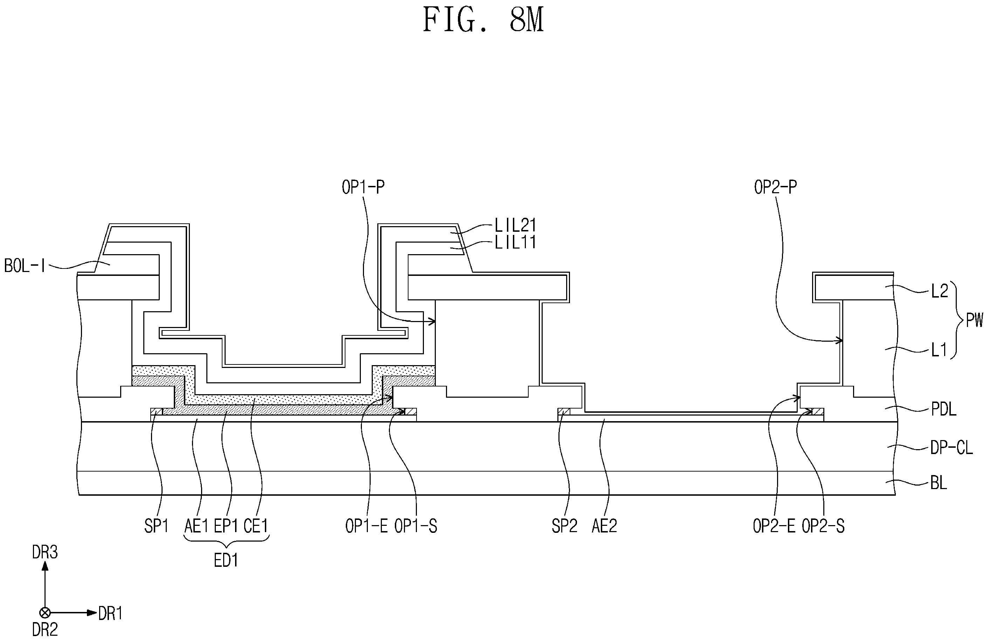

Thereafter, referring to FIGS. 8M and 8N, the method of manufacturing a display panel according to the present disclosure may include an operation of forming the first lower organic layer BOL1 (or a lower organic layer) between the second partition wall layer L2 and the (1-1)th and (2-1)th lower encapsulation inorganic patterns LIL11 and LIL21 (or a lower encapsulation inorganic pattern). The operation of forming the first lower organic layer BOL1 may include an operation of depositing the preliminary lower organic layer BOL-I on the partition wall PW and the (1-1)th and (2-1)th lower encapsulation inorganic patterns LIL11 and LIL21, an operation of irradiating the preliminary lower organic layer BOL-I with the light LT, and an operation of removing a remaining portion the preliminary lower organic layer BOL-I except for a portion of the preliminary lower organic layer BOL-I formed under the (1-1)th and (2-1)th lower encapsulation inorganic patterns LIL11 and LIL21.

First, referring to FIG. 8M, in the operation of forming the first lower organic layer BOL1 (see FIG. 8N), the preliminary lower organic layer BOL-I may be deposited on the partition wall PW and the (1-1)th and (2-1)th lower encapsulation inorganic patterns LIL11 and LIL21. For example, the preliminary lower organic layer BOL-I may be deposited on the (1-1)th and (2-1)th lower encapsulation inorganic patterns LIL11 and LIL21 and the partition wall PW and may be also deposited in the second partition wall opening OP2-P. The preliminary lower organic layer BOL-I may include an organic material.

Thereafter, referring to FIG. 8N, the operation of forming the first lower organic layer BOL1 may include an operation of irradiating the preliminary lower organic layer BOL-I with the light LT and an operation of removing a remaining portion of the preliminary lower organic layer BOL-I except for a portion of the preliminary lower organic layer BOL-I formed under the (1-1)th and (2-1)th lower encapsulation inorganic patterns LIL11 and LIL21.

The light LT with which the preliminary lower organic layer BOL-I is irradiated may have an ultraviolet wavelength range. For example, the light LT may have a wavelength of 350 nm to 400 nm.

The (1-1)th lower encapsulation inorganic pattern LIL11 may include a plurality of inorganic patterns (e.g., the plurality of etched inorganic layers S1_I and S2_I or S1, S2, S3, S4, and S5 (see FIG. 6)). The plurality of inorganic patterns S1, S2, S3, S4, and S5 may have DBR characteristics. That is, the plurality of inorganic patterns S1, S2, S3, S4, and S5 may reflect a light having a specific wavelength range. For example, the plurality of inorganic patterns S1, S2, S3, S4, and S5 may reflect a light having a wavelength of 350 nm to 400 nm.

As a result, the remaining portion of the preliminary lower organic layer BOL-I except for the portion of the preliminary lower organic layer BOL-I formed under the (1-1)th lower encapsulation inorganic pattern LIL11 may be removed by the light LT. The first lower organic layer BOL1 may be formed from the portion of the preliminary lower organic layer BOL-I formed below the (1-1)th lower encapsulation inorganic pattern LIL11.

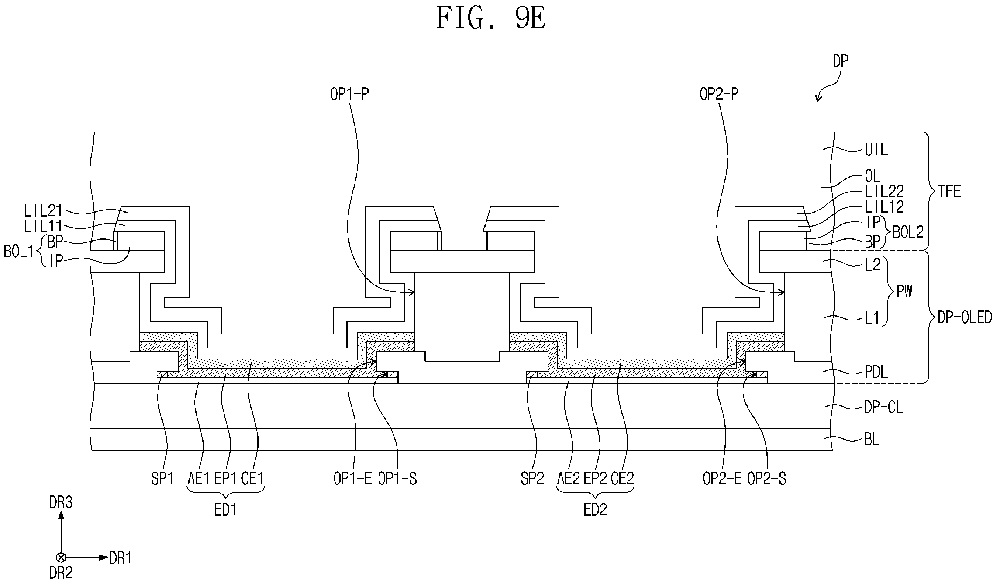

FIGS. 9A to 9D illustrate an operation of forming the second light emitting element ED2, and FIG. 9E illustrates an operation of forming the encapsulation organic film OL and the upper encapsulation inorganic film UIL. The operation of forming the second light emitting element ED2 may be substantially the same as the operation of forming the first light emitting element ED1 (see FIGS. 8A to 8N).

Referring to FIG. 9A, the method of manufacturing a display panel according to the present disclosure may include an operation of forming the second light emitting pattern EP2 and the second cathode CE2 and an operation of forming the (1-2)th and (2-2)th lower encapsulation inorganic layers LIL12_I and LIL22_I. The same/similar reference numerals are used and described for the same/similar components with reference to FIGS. 1 to 8N, and a duplicated description thereof will be omitted.

The operation of forming the second light emitting pattern EP2 and the second cathode CE2 may be substantially the same as the operation of forming the first light emitting pattern EP1 and the first cathode CE1 of FIG. 8F. In the operation of forming the second light emitting pattern EP2, a (1-2)th dummy layer D12-I spaced apart from the second light emitting pattern EP2 may be formed on the partition wall PW together, and in the operation of forming the second cathode CE2, a (2-2)th dummy layer D22-I spaced apart from the second cathode CE2 may be formed on the partition wall PW together. The (1-2)th dummy layer D12-I and the (2-2)th dummy layer D22-I may form a second dummy layer DMP2-I.

The operation of forming the (1-2)th and (2-2)th lower encapsulation inorganic layers LIL12_I and LIL22_I may be substantially the same as the operation of forming the (1-1)th and (2-1)th lower encapsulation inorganic layers LIL11_I and LIL21_I, which is described through FIGS. 8G to 8J. The (1-2)th lower encapsulation inorganic layer LIL12_I may include the plurality of inorganic layers S1_I and S2_I (see FIG. 8I). The plurality of inorganic layers S1_I and S2_I may have DBR characteristics. That is, the plurality of inorganic layers S1_I and S2_I may reflect a light having a specific wavelength range.

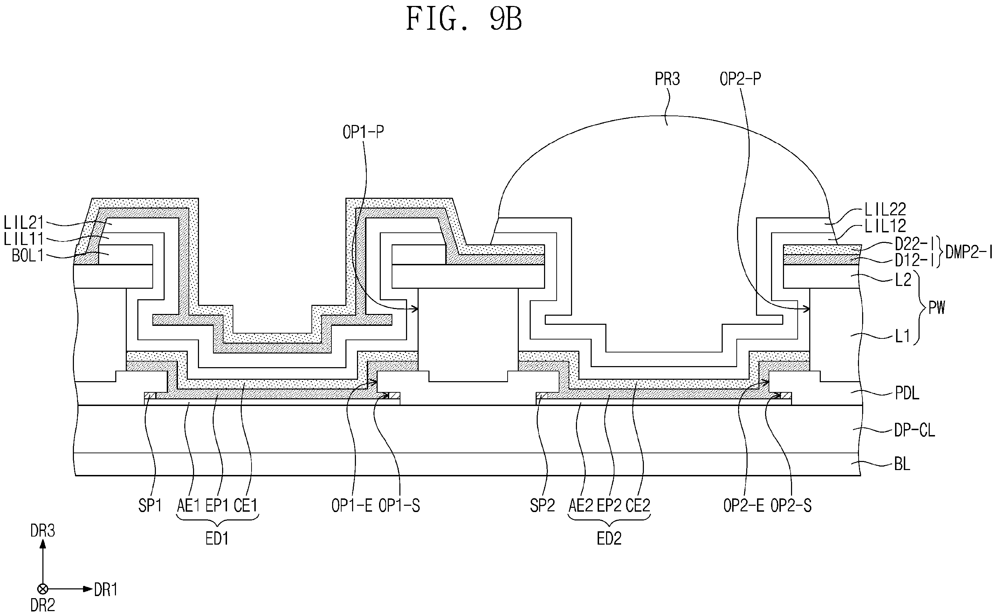

Thereafter, referring to FIG. 9B, the method of manufacturing a display panel according to the present disclosure may include an operation of forming a third photoresist layer PR3 and an operation of forming the (1-2)th and (2-2)th lower encapsulation inorganic patterns LIL12 and LIL22.

In the operation of forming the third photoresist layer PR3, the third photoresist layer PR3 may be formed by forming the preliminary photoresist layer, and then patterning the preliminary photoresist layer using a photo mask. Through the patterning process, the third photoresist layer PR3 may be formed in a pattern form corresponding to the second light emitting opening OP2-E.

In the operation of forming the (1-2)th and (2-2)th lower encapsulation inorganic patterns LIL12 and LIL22, the (1-2)th lower encapsulation inorganic layer LIL12_I and the (2-2)th lower encapsulation inorganic layer LIL22_I are dry-etched and are patterned to remove a portion overlapping a remaining anode (e.g., the first anode AE1) except for the corresponding second anode AE2 among the (1-2)th and (2-2)th lower encapsulation inorganic layers LIL12_I and LIL22_I. The (1-2)th and (2-2)th lower encapsulation inorganic patterns LIL12 and LIL22 overlapping the corresponding second light emitting opening OP2-E may be formed from the patterned (1-2)th and (2-2)th lower encapsulation inorganic layers LIL12_I and LIL22_I.

FIG. 9B illustratively illustrates the (1-2)th and (2-2)th lower encapsulation inorganic patterns LIL12 and LIL22 having inclined side surfaces, but embodiments according to the present disclosure are not limited thereto. For example, the side surfaces of the (1-2)th and (2-2)th lower encapsulation inorganic patterns LIL12 and LIL22 may be vertically aligned.

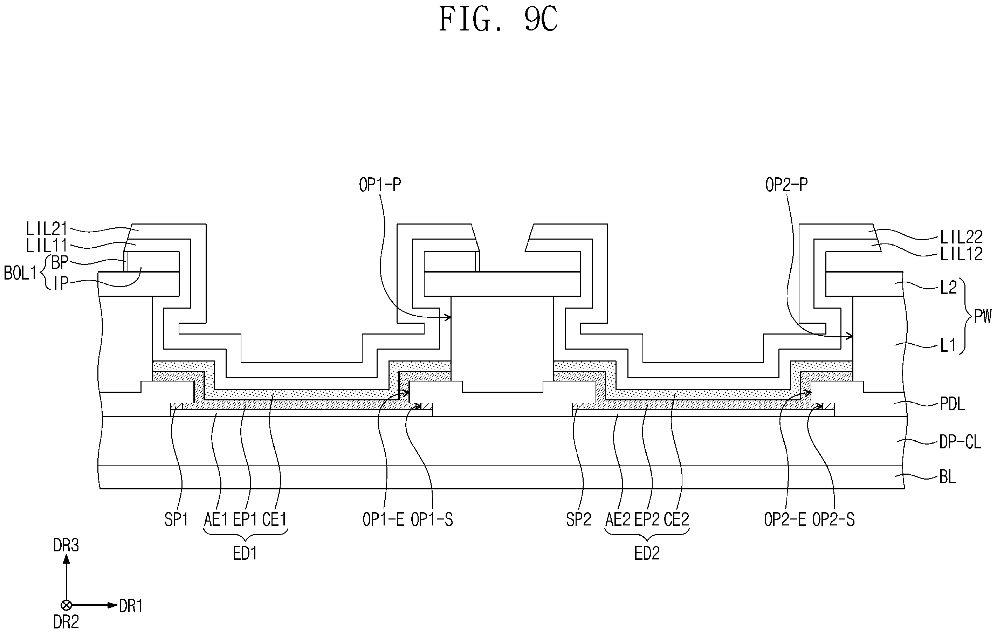

Thereafter, referring to FIG. 9C, the method of manufacturing a display panel according to the present disclosure may include an operation of removing the second dummy layers DMP2-I (see FIG. 9B) and the second light emitting pattern EP2 and the second cathode CE2 formed inside the first partition wall opening OP1-P.

In the operation of removing the second dummy layers DMP2-I and the second light emitting pattern EP2 and the second cathode CE2 formed inside the first partition wall opening OP1-P, the second dummy layers DMP2-I and the second light emitting pattern EP2 and the second cathode CE2 formed inside the first partition wall opening OP1-P may be removed through wet etching.

A portion of the first lower organic layer BOL1 exposed to an etchant during the process may include a material changed by a chemical reaction. That is, the first lower organic layer BOL1 may be divided into the inner part IP and the boundary part BP. The inner part IP of the first lower organic layer BOL1 may be defined as a portion located between the third part P3 (see FIG. 5) of the lower encapsulation inorganic patterns LIL11 and LIL21 and the partition wall PW, and the boundary part BP of the first lower organic layer BOL1 may be defined as a portion including a material exposed to the etchant and changed by a chemical reaction. The boundary part BP may be formed by surrounding the inner part IP on a plane (or in a plan view).

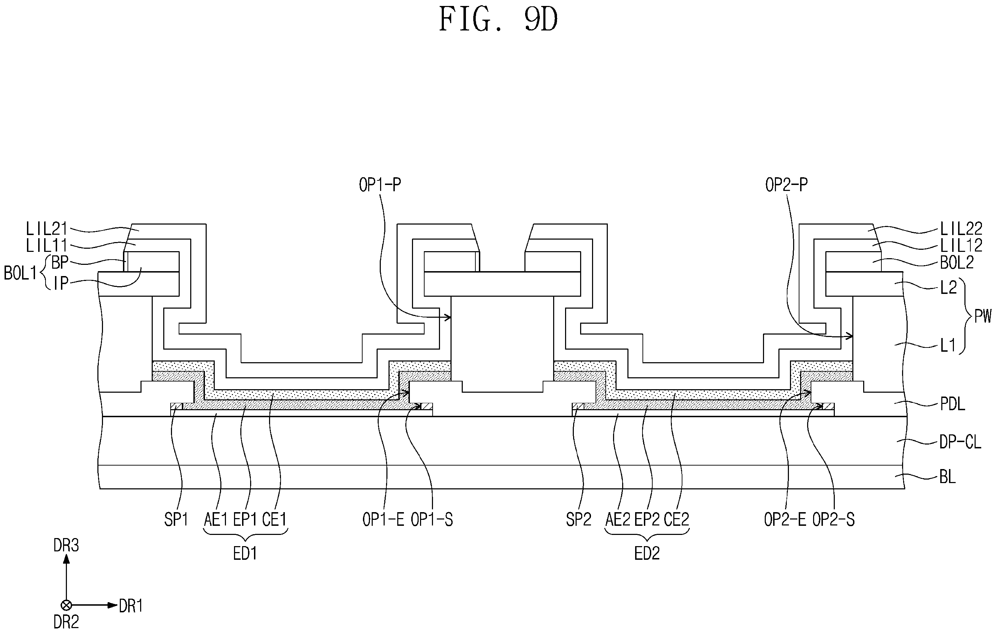

Thereafter, referring to FIG. 9D, the method of manufacturing a display panel according to the present disclosure may include an operation of forming the second lower organic layer BOL2 between the second partition wall layer L2 and the (1-2)th and (2-2)th lower encapsulation inorganic patterns LIL12 and LIL22. The operation of forming the second lower organic layer BOL2 may be substantially the same as the operation of forming the first lower organic layer BOL1 described in FIGS. 8M and 8N.

Referring to FIG. 9E, the method of manufacturing a display panel according to the present disclosure may include an operation of completing the display panel DP by forming the encapsulation organic film OL and the upper encapsulation inorganic film UIL. The encapsulation organic film OL may be formed by applying an organic material in an inkjet method, but embodiments according to the present disclosure are not limited thereto. The encapsulation organic film OL provides a flattened upper surface. Thereafter, the upper encapsulation inorganic film UIL may be formed by depositing an inorganic material. Therefore, the display panel DP including the base layer BL, the circuit element layer DP-CL, the display element layer DP-OLED, and the thin film encapsulation Layer TFE may be formed.

An operation of forming the third partition wall opening OP3-P (see FIG. 7) and the third light emitting opening OP3-E (see FIG. 7) corresponding to a different color light emitting area (e.g., the third light emitting area PXA-B (see FIG. 4)) in the partition wall PW and the pixel defining film PDL, an operation of forming the third light emitting element ED3 (see FIG. 7), an operation of forming the lower encapsulation inorganic pattern LIL13 and LIL23 (see FIG. 7) that cover the third light emitting pattern EP3, and an operation of forming the third lower organic layer BOL3 (see FIG. 7) may be further performed between the operation of forming the second lower organic layer BOL2 and the operation of completing the display panel DP. Therefore, the display panel DP including the first to third light emitting elements ED1, ED2, and ED3 corresponding to the plurality of light emitting areas PXA-R, PXA-G, and PXA-B, the lower encapsulation inorganic patterns LIL1 and LIL2 (see FIG. 7) corresponding to the first to third light emitting elements ED1, ED2, and ED3, and the third lower organic layer BOL3 (see FIG. 7) as illustrated in FIG. 8 may be formed.

As described above, a display panel includes a lower organic layer located between a partition wall and a lower encapsulation inorganic pattern, and thus a phenomenon in which foreign substances are introduced between the partition wall and the lower encapsulation inorganic pattern may be relatively reduced or removed. Thus, pixel defects (dart spots, pixel shrinkage, or the like) of a display panel, which are caused by foreign substances, may be relatively reduced or removed.

Although the description has been made above with reference to aspects of some embodiments of the present disclosure, it may be understood that those skilled in the art or those having ordinary knowledge in the art may variously modify and change the present disclosure without departing from the spirit and technical scope of the present disclosure described in the claims, and their equivalents. Thus, the technical scope of embodiments according to the present disclosure is not limited to the detailed description of the specification, but should be defined by the claims, and their equivalents.

## Claims

1. A display panel (DP) comprising:
a base layer (BL);
a pixel defining film (PDL) on the base layer (BL) and in which a light emitting opening (OP-E) is defined;
a partition wall (PW) on the pixel defining film (PDL) and in which a partition wall opening (OP-P) overlapping the light emitting opening (OP-E) is defined;
a light emitting element (ED) including an anode (AE), an intermediate layer (EP), and a cathode (CE) in contact with the partition wall (PW) and located in the partition wall opening (OP-P);
a lower encapsulation inorganic pattern (LIL) including a first part (P1) in the partition wall opening (OP-P), a second part (P2) extending from the first part (P1) in a thickness direction of the base layer (BL), and a third part (P3) extending from the second part (P2) in a direction away from the partition wall opening (OP-P) and spaced apart from the partition wall (PW) on a cross section; and
a lower organic layer (BOL) between the third part (P3) of the lower encapsulation inorganic pattern (LIL) and the partition wall (PW).

2. The display panel (DP) of claim 1, further comprising:
an encapsulation organic film (OL) on the lower encapsulation inorganic pattern (LIL),
wherein the lower organic layer (BOL) contacts the encapsulation organic film (OL).

3. The display panel (DP) of claim 2, wherein the lower organic layer (BOL) includes an inner part (IP) and a boundary part (BP) formed by surrounding the inner part (IP) in a plan view, and
the boundary part (BP) and the encapsulation organic film (OL) contact each other.

4. The display panel (DP) of any one of claims 1 to 3, wherein the lower encapsulation inorganic pattern (LIL) includes a first lower encapsulation inorganic pattern (LIL1) on the cathode (CE) and a second lower encapsulation inorganic pattern (LIL2) on the first lower encapsulation inorganic pattern (LIL1), and
the first lower encapsulation inorganic pattern (LIL1) includes a plurality of inorganic patterns (S1, S2, S3, S4, S5), which are repeating laminates.

5. The display panel (DP) of claim 4, wherein a thickness (T_S) of at least one inorganic pattern among the plurality of inorganic patterns (S1, S2, S3, S4, S5) is in a range of 175 nanometer to 200 nanometer.

6. The display panel (DP) of claim 4 or 5, wherein the plurality of inorganic patterns (S1, S2, S3, S4, S5) is configured to reflect a light (LT) having a wavelength of 350 nanometer to 400 nanometer.

7. The display panel (DP) of any one of claims 4 to 6, wherein thicknesses (T_S) of the plurality of inorganic patterns (S1, S2, S3, S4, S5) are equal.

8. The display panel (DP) of any one of claims 4 to 7, wherein each of the plurality of inorganic patterns (S1, S2, S3, S4, S5) includes a silicon nitride (SiNₓ).

9. The display panel (DP) of any one of claims 4 to 8, wherein each of the plurality of inorganic patterns (S1, S2, S3, S4, S5) includes a first sub pattern (SB1) and a second sub pattern (SB2), and the first sub pattern (SB1) and the second sub pattern (SB2) are sequential and repeating laminates.

10. The display panel (DP) of claim 9, wherein the first sub pattern (SB1) is richer in silicon than the second sub pattern (SB2), and/or wherein the second sub pattern (SB2) is richer in nitrogen than the first sub pattern (SB1).

11. The display panel (DP) of claim 9 or 10, wherein a thickness of the first sub pattern (SB1) is equal to a thickness of the second sub pattern (SB2).

12. A method of manufacturing a display panel (DP), the method comprising:
providing a preliminary display panel (DP-I) including a base layer (BL), a pixel defining film (PDL) on the base layer (BL), a first preliminary partition wall layer (L1-I) on the pixel defining film (PDL), and a second preliminary partition wall layer (L2-I) on the first preliminary partition wall layer (L1-I);
etching the first preliminary partition wall layer (L1-I) and the second preliminary partition wall layer (L2-I) to form a first partition wall layer (L1) and a second partition wall layer (L2) in which a partition wall opening (OP-P, OP1-P, OP2-P, OP3-P) is defined;
forming a light emitting pattern (EP, EP1, EP2, EP3) and a cathode (CE, CE1, CE2, CE3) in the partition wall opening (OP-P, OP1-P, OP2-P, OP3-P);
forming a lower encapsulation inorganic pattern (LIL) on the cathode (CE, CE1, CE2, CE3); and
forming a lower organic layer (BOL, BOL1, BOL2, BOL3) between the second partition wall layer (L2) and the lower encapsulation inorganic pattern (LIL).

13. The method of claim 12, wherein the forming of the lower organic layer (BOL, BOL1, BOL2, BOL3) includes:
depositing a preliminary lower organic layer (BOL-I) on the second partition wall layer (L2) and the lower encapsulation inorganic pattern (LIL);
irradiating the preliminary lower organic layer (BOL-I) with a light (LT); and
removing a remaining portion of the preliminary lower organic layer except for a portion of the preliminary lower organic layer (BOL-I) formed under the lower encapsulation inorganic pattern (LIL).

14. The method of claim 12 or 13, wherein the forming of the lower encapsulation inorganic pattern (LIL1) includes:
depositing a (1-1)^{th} sub layer (SB11_I) on the cathode (CE1, CE2, CE3); and
depositing a (2-1)^{th} sub layer (SB21_I) on the (1-1)^{th} sub layer (SB11_I),
wherein the (1-1)^{th} sub layer (SB11_I) and the (2-1)^{th} sub layer (SB21_I) form a first inorganic layer (S1_I), and
a thickness of the first inorganic layer (S1_I) is a half of a wavelength of the light (LT).

15. The method of claim 14, wherein the depositing of the (1-1)^{th} sub layer (SB11_I) on the cathode (CE1, CE2, CE3) includes:
inputting a gas containing silicon (G_SI) and an argon gas (AR); and
inputting a gas containing nitrogen (G_N) and the argon gas (AR), and/or
wherein the depositing of the (2-1)^{th} sub layer (SB21_I) on the (1-1)^{th} sub layer (SB11_I) includes:
inputting a gas containing silicon (G_SI), a gas containing nitrogen (G_N), and an argon gas (AR); and
inputting the gas containing nitrogen (G_N) and the argon gas (AR).
